# EUROPEAN PATENT APPLICATION

(11) **EP 1 014 448 A2**
(43) Date of publication of application: **28.06.2000**
(21) Application number: 99125534.0
(22) Date of filing: 22.12.1999
(51) Int. Cl.: H01L 27/115, H01L 21/8247, H01L 21/762, H01L 21/336, H01L 29/788

(54) **Nonvolatile semiconductor memory device and method of manufacturing the same**

(30) Priority: 25.12.1998 JP 37075798; 26.10.1999 JP 30372699
(71) Applicant: KABUSHIKI KAISHA TOSHIBA, Kawasaki-shi, Kanagawa 210-8520 (JP)
(72) Inventor: Shirota, Riichiro, 1-1-1 Shibaura, Minato-ku Tokyo 105-8001 (JP); Takeuchi, Yuji, 1-1-1 Shibaura, Minato-ku Tokyo 105-8001 (JP); Kamiya, Eiji, 1-1-1 Shibaura, Minato-ku Tokyo 105-8001 (JP); Meguro, Hisataka, 1-1-1 Shibaura, Minato-ku Tokyo 105-8001 (JP); Iizuka, Hirohisa, 1-1-1 Shibaura, Minato-ku Tokyo 105-8001 (JP); Aritome, Seiichi, 1-1-1 Shibaura, Minato-ku Tokyo 105-8001 (JP); Koido, Naoki, 1-1-1 Shibaura, Minato-ku Tokyo 105-8001 (JP); Goda, Akira, 1-1-1 Shibaura, Minato-ku Tokyo 105-8001 (JP); Tsunoda, Hiroaki, 1-1-1 Shibaura, Minato-ku Tokyo 105-8001 (JP)
(74) Representative: HOFFMANN - EITLE

(57) **Abstract**

This invention relates to a nonvolatile semiconductor memory capable of electrically rewriting the data. A memory cell transistor formed in an element formation region in a semiconductor substrate (2) has a gate electrode structure including a source/drain diffused layer (9), a gate insulating film (5) formed on the element formation region, a floating gate (6), a gate-to-gate insulating film (7), and a control gate (8). A barrier insulating film (12) for suppressing excess etching is formed above the semiconductor substrate excluding the vicinity of the gate electrode structure.

## Description

This invention relates to a semiconductor device and a method of manufacturing the same, and more particularly to the suppression of overetching occurred in element isolating regions in making contact holes.

Semiconductor devices using STI (Shallow Trench Insulation) to isolate elements, such as transistors or memory cells in an EEPROM, from each other have been widely used.

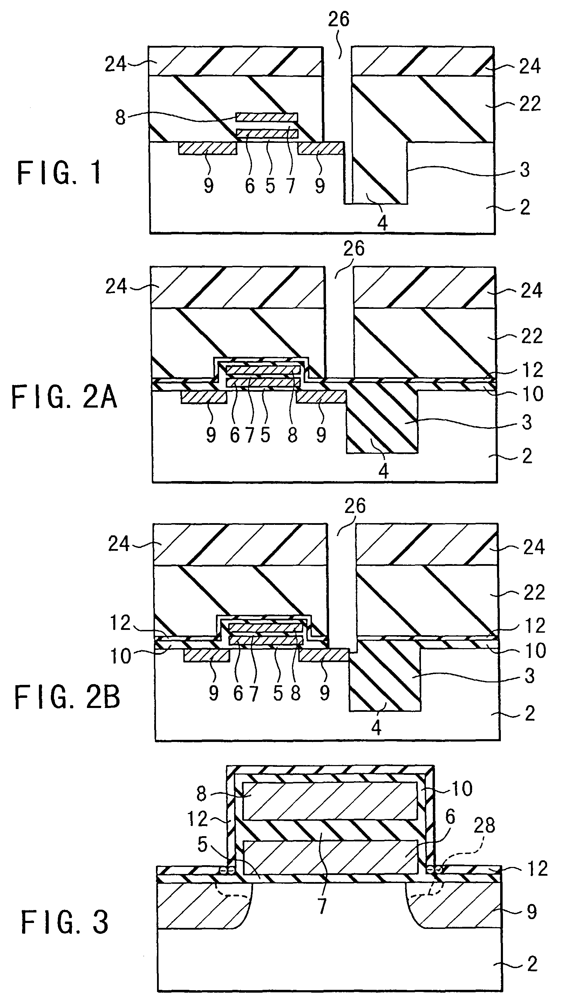

In such semiconductor devices, when a contact hole is made to make contact with an element, if the contact hole comes off the element region and eats into the element isolating region, the contact hole can penetrate to the semiconductor substrate. FIG. 1 is a sectional view of a semiconductor device in which such penetration has occurred.

As shown in FIG. 1, a trench 3 is formed in a semiconductor substrate 2. In the trench 3, an element isolation insulating film 4 is embedded. The trench 3 and element isolation insulating film 4 constitute an STI. The STI delimits an element region in which an element is to be formed. In the element region, a transistor has been formed. The transistor is composed of a gate electrode structure including a gate insulating film 5, a floating gate 6, a gate-to-gate insulating film 7, and a control gate 8, and a source/drain region (diffused layer) 9 formed in the element region excluding the portion under the gate electrode structure. On the substrate having the element region in which the STI and a memory cell have been formed, an interlayer insulating film 22 has been formed. In the interlayer insulating film 22, a contact hole 26 leading to the source/drain region 9 has been formed.

To make the contact hole 26 shown in FIG. 1, a resist pattern 24 of photoresist with openings according to the opening pattern of the contact hole 26 is formed on the interlayer insulating film 22. Thereafter, with the resist pattern 24 as a mask, the interlayer insulating film 22 is etched using RIE (reactive ion etching) techniques. In this way, the contact hole 26 is made in the interlayer insulating film 22.

When the contact hole 26 comes off the source/drain region 9 and overlaps with the STI, however, the element isolation insulating film 4 is etched and the contact hole 26 penetrates through the side face or underside of the trench 3 to the substrate 2.

In a conventional semiconductor substrate, to prevent such penetration, a buffer insulating film 10 made of buffer material (e.g., silicon oxide) is formed all over the surface above the substrate 2 and thereafter a barrier insulating film 12 made of, for example, silicon nitride is formed all over the surface above the substrate 2 as shown in FIG. 2A. Silicon nitride has an etching selectivity to silicon oxide. Then, for example, an interlayer insulating film 22 made of silicon oxide is formed. On the interlayer insulating film 22, a resist pattern 24 is formed. Thereafter, with the resist pattern 24 as a mask, the interlayer insulating film 22 is etched using RIE techniques, thereby making the contact hole 26 reaching the barrier insulating film 12.

Then, as shown in FIG. 2B, the barrier insulating film 12 and the buffer insulating film 10 under the barrier insulating film 12 are etched by RIE using the resist pattern 24 as a mask, which thereby makes the contact hole 26 that reaches the source/drain region 9.

As described above, forming the barrier insulating film 12 all over the surface above the substrate 2 prevents the penetration. The barrier insulating film 12 also helps prevent contamination from the outside.

However, when the conventional transistors shown in FIGS. 1, 2A, and 2B, are used as memory cells in an EEPROM and data is written into and deleted from the memory cells repeatedly, this causes the problem of decreasing the reliability of the memory cells, which will be explained below.

In a memory cell in the EEPROM, when the data is written or deleted, the data is generally exchanged between the floating gate 6 and substrate 2. In a case where the barrier insulating film 12 is provided on the gate electrode structure as in the conventional transistor, electrons are injected into the barrier insulating film 12 each time data is written and deleted. This state is shown in FIG. 3.

As shown in FIG. 3, when electrons have been injected into a portion near the edge of the gate electrode structure, the portion near the edge is negatively charged. As a result, a part 28 of the source/drain region 9 under the portion near the edge turns into a depletion layer. This causes the drain current (on current) I_{D} in the transistor to decrease, leading to the problem of lowering the reliability of the memory cells.

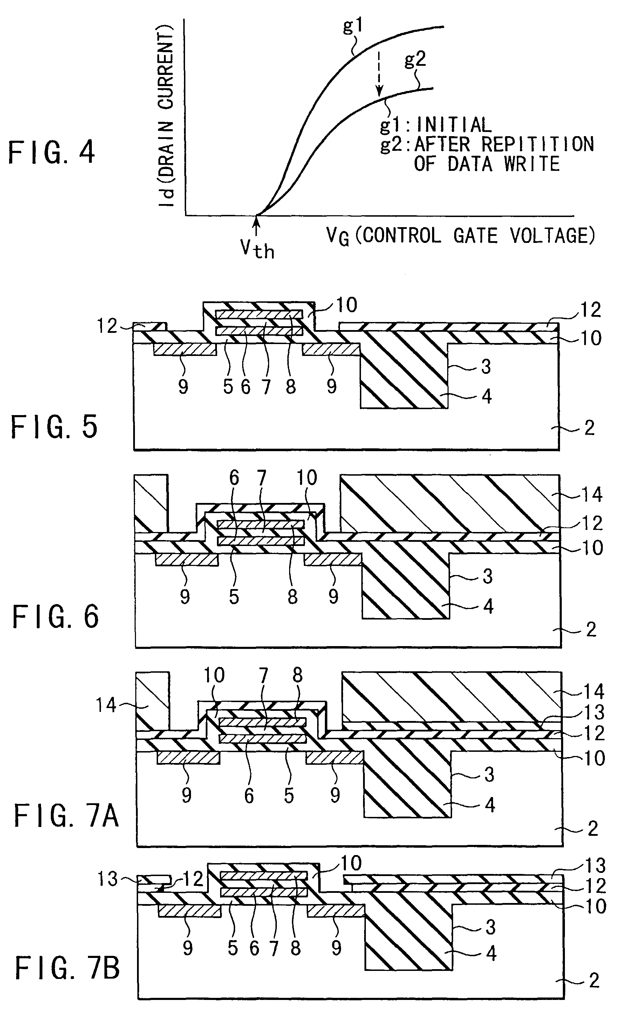

FIG. 4 shows a current-voltage characteristic diagram of the conventional transistor, particularly the relationship between the drain current I_{D} and the voltage V_{G} of the control gate 8.

In FIG. 4, curve G1 is a current-voltage characteristic curve of the transistor in the initial state (before the repetition of writing and erasing) and curve G2 is a current-voltage characteristic curve of the transistor after the writing and erasing have been done repeatedly.

Those curves G1 and G2 were obtained in a state where the amount of charge in the floating gate 6 was adjusted in such a manner that the amount in the transistor in the initial state was equal to the amount in the transistor after the repetition of writing and erasing and the threshold voltage V_{TH} of the transistor viewed from the control gate 8 was the same.

It is, accordingly, an object of the present invention to provide a semiconductor device capable of preventing a decrease in the reliability as much as possible and a method of manufacturing the semiconductor device.

The foregoing object is accomplished by providing a semiconductor device comprising: a semiconductor substrate having an element isolating region and an element formation region; a transistor having a first and a second diffused layer formed in the element formation region and a gate electrode structure formed on the element formation region between the first and second diffused layers; and a barrier insulating film formed above the semiconductor substrate excluding the vicinity of the gate electrode structure.

With the semiconductor device constructed as described above, since the barrier insulating film has been formed above the substrate excluding the vicinity of the gate electrode structure of the transistor, the barrier insulating film is prevented from being charged. Consequently, the diffused layers in the transistor never turn to depletion layers, which prevents the on current in the transistor from decreasing.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a sectional view of a conventional semiconductor device;
FIGS. 2A and 2B are each sectional views showing manufacturing steps of other conventional semiconductor devices;
FIG. 3 is a sectional view to help explain the problem of another conventional semiconductor device;
FIG. 4 shows a current-voltage characteristic of another semiconductor device;
FIG. 5 is a sectional view of a semiconductor device according to a first embodiment of the present invention;
FIG. 6 is a sectional view showing an important manufacturing process of the semiconductor device according to the first embodiment;
FIGS. 7A and 7B are sectional views showing manufacturing processes to help explain a method of manufacturing a semiconductor device according to a second embodiment of the present invention;
FIG. 8 is an equivalent circuit diagram of a NAND cell EEPROM;
FIG. 9A is a plan view of a NAND cell EEPROM according to a third embodiment of the present invention;
FIG. 9B is a sectional view taken along line 9B-9B of FIG. 9A;
FIG. 9C is a sectional view taken along line 9C-9C of FIG. 9A;
FIG. 10 is an equivalent circuit diagram of an AND cell EEPROM;
FIG. 11 is a plan view of an AND cell EEPROM according to a fourth embodiment of the present invention;
FIGS. 12A, 12B, 12C, 12D, 12E, 12F, and 12G are sectional views showing manufacturing processes to help explain a method of manufacturing a NAND cell EEPROM according to a fifth embodiment of the present invention;
FIGS. 13A, 13B, 13C, 13D, 13E, 13F, and 13G are sectional views showing manufacturing processes to help explain a method of manufacturing a NAND cell EEPROM according to the fifth embodiment;
FIGS. 14A, 14B, 14C, 14D, 14E, 14F, and 14G are sectional views showing manufacturing processes to help explain a method of manufacturing a NAND cell EEPROM according to a sixth embodiment of the present invention;
FIGS. 15A, 15B, 15C, 15D, 15E, 15F, and 15G are sectional views showing manufacturing processes to help explain a method of manufacturing a NAND cell EEPROM according to the sixth embodiment;
FIG. 16A is a plan view of a conventional NAND cell EEPROM;
FIG. 16B is a sectional view taken along line 16B-16B of FIG. 16A;
FIG. 16C is a sectional view taken along line 16C-16C of FIG. 16A;
FIG. 16D is a sectional view taken along line 16D-16D of FIG. 16A;
FIG. 17 is an equivalent circuit diagram of a conventional NAND cell EEPROM;
FIG. 18A is a plan view of a conventional NAND cell EEPROM with a booster plate;
FIG. 18B is a sectional view taken along line 18B-18B of FIG. 18A;
FIG. 18C is a sectional view taken along line 18C-18C of FIG. 18A;
FIG. 18D is a sectional view taken along line 18D-18D of FIG. 18A;
FIG. 19A is a sectional view to help explain a method of forming a bit line contact;
FIG. 19B is a sectional view to help explain a method of forming a bit line contact;
FIG. 19C is a sectional view to help explain a method of forming a bit line contact;
FIG. 20A is a plan view of a NAND cell EEPROM with a booster plate according to a seventh embodiment of the present invention;
FIG. 20B is a sectional view taken along line 18B-18B of FIG. 20A;
FIG. 20C is a sectional view taken along line 18C-18C of FIG. 20A;
FIG. 20D is a sectional view taken along line 20D-20D in FIG. 20A;
FIG. 21 is an equivalent circuit diagram of the NAND cell EEPROM with a booster plate;
FIGS. 22A, 22B, 22C, 22D, 22E, 22F, and 22G are sectional views showing manufacturing processes to help explain a method of manufacturing a NAND cell EEPROM with a booster plate according to the seventh embodiment;
FIGS. 23A, 23B, 23C, 23D, 23E, 23F, and 23G are sectional views showing manufacturing processes to help explain a method of manufacturing a NAND cell EEPROM with a booster plate according to the seventh embodiment;
FIGS. 24A, 24B, 24C, 24D, 24E, 24F, and 24G are sectional views showing manufacturing processes to help explain a method of manufacturing a NAND cell EEPROM with a booster plate according to the seventh embodiment;
FIG. 25A is a plan view of a NAND cell EEPROM with a booster plate according to an eighth embodiment of the present invention;
FIG. 25B is a sectional view taken along line 25B-25B of FIG. 25A;
FIG. 25C is a sectional view taken along line 25C-25C of FIG. 25A;
FIG. 25D is a sectional view taken along line 25D-25D of FIG. 25A;
FIG. 26A is a plan view of a NAND cell EEPROM with a source wire according to a ninth embodiment of the present invention;
FIG. 26B is a sectional view taken along line 26B-26B of FIG. 26A;
FIG. 26C is a sectional view taken along line 26C-26C of FIG. 26A;
FIG. 26D is a sectional view taken along line 26D-26D of FIG. 26A;
FIG. 26E is a sectional view taken along line 26E-26E of FIG. 26A;
FIGS. 27A, 27B, 27C, and 27D are sectional views showing manufacturing processes to help explain a method of manufacturing a NAND cell EEPROM with a source line according to the ninth embodiment;
FIGS. 28A, 28B, 28C, and 28D are sectional views showing manufacturing processes to help explain a method of manufacturing a NAND cell EEPROM with a source line according to the ninth embodiment;
FIGS. 29A, 29B, 29C, and 29D are sectional views showing manufacturing processes to help explain a method of manufacturing a NAND cell EEPROM with a source line according to the ninth embodiment;
FIG. 30A is a plan view of a NAND cell EEPROM with a source wire according to a tenth embodiment of the present invention;
FIG. 30B is a sectional view taken along line 30B-30B of FIG. 30A; and
FIG. 30C is a sectional view taken along line 30C-30C of FIG. 30A.

Hereinafter, referring to the accompanying drawings, embodiments of the present invention will be explained.

### (First Embodiment)

FIG. 5 is a sectional view of a semiconductor device according to a first embodiment of the present invention.

As shown in FIG. 5, for example, in a p-type silicon substrate 2, an element isolating shallow trench 3 is formed. In the shallow trench 3, an element isolation insulating film 4 is embedded. The shallow trench 3 and element isolation insulating film 4 constitute an STI, which delimits an element region in which an element is to be formed, at the surface of the substrate 2. In the element region, a transistor has been formed. The transistor is composed of a gate electrode structure including a gate insulating film 5, a floating gate 6, a gate-to-gate insulating film 7, and a control gate 8, and a source/drain region, such as an n-type diffused layer 9, formed in the element region excluding the portion under the gate electrode structure. On the gate electrode structure, diffused layer 9, and element isolation insulating film 4, an insulating film 10 made of buffer material (e.g., silicon oxide) has been formed. Then, a barrier insulating film 12 made of silicon nitride has been formed on the portion of the insulating film 10 excluding the vicinity of the gate electrode structure. The barrier insulating film 12 remains on the element isolation insulating film 4 adjacent to a contact formation region (or the diffused layer 9 in the first embodiment).

In the semiconductor device according to the first embodiment, since the barrier insulating film 12 has not been formed in the vicinity of the gate electrode structure, even if data is written and deleted repeatedly, a part of the diffused layer 9 will not turn to a depletion layer. Thus, it is possible to prevent the drain current (on current) in the transistor from decreasing, which prevents a decrease in the reliability as mush as possible.

Next, a method of manufacturing a semiconductor device according to the first embodiment will be explained.

FIG. 6 is a sectional view showing an important manufacturing process of a semiconductor device according to the first embodiment.

As shown in FIG. 6, a shallow trench 3 is formed in the region in which an element isolating region is to be formed, in, for example, a p-type silicon substrate 2. Then, the shallow trench 3 is filled with the element isolation insulating film 4 made of silicon oxide. Then, on the entire surface of the substrate 2, a gate insulating film 5, a conductive film 6 to act as a floating gate, an insulating film 7, and a conductive film 8 to act as a control gate are stacked one on top of another in that order. Patterning these films produces a gate electrode structure. Then, using the gate electrode structure as a mask, n-type impurity ions are implanted into the portions corresponding to both sides of the gate electrode structure, thereby forming a diffused layer 9 to act as a source and a drain. Next, after a buffer insulating film 10 made of silicon oxide has been formed on the entire surface of the substrate 2, a barrier insulating film 12 made of silicon nitride is formed.

Thereafter, a resist pattern 14 made of photoresist with an opening near the gate electrode structure is formed on the barrier insulating film 12. Then, using the resist pattern 14 as a mask, the barrier insulating film 12 is etched by isotropic dry etching or RIE. In this way, the barrier insulating film 12 is removed from the vicinity of the gate electrode structure. The barrier insulating film is left on the element isolation insulating film 4 adjacent to the contact formation region.

Next, after the resist pattern 14 has been removed, annealing is done to improve the quality of the buffer insulating film 10. Then, annealing is done to activate the diffused layer 9, thereby producing a semiconductor device shown in FIG. 5.

Thereafter, an interlayer insulating film (not shown) is formed all over the surface above the substrate 2. Then, a contact hole (not shown) is made in the interlayer insulating film. Following that, the contact hole is filled with conductive material, thereby forming a contact (not shown) made of the conductive material within the contact hole. This completes a semiconductor device according to the first embodiment.

### (Second Embodiment)

A second embodiment of the present invention relates to a method of manufacturing semiconductor devices.

FIGS. 7A and 7B are sectional views showing manufacturing processes to help explain a method of manufacturing a semiconductor device according to the second embodiment.

First, using the manufacturing method explained in the first embodiment, the component elements up to the barrier insulating film 12 have been formed all over the surface above the substrate 2.

Next, as shown in FIG. 7A, a silicon oxide film 13 is formed on the barrier insulating film 12. Then, on the silicon oxide film 13, a resist pattern 14 made of photoresist with an opening near the gate electrode structure is formed. Following that, using the resist pattern 14 as a mask, the barrier insulating film 12 is etched by dry etching or wet etching.

Next, as shown in FIG. 7B, after the resist pattern 12 has been removed, the barrier insulating film 12 is removed from the vicinity of the gate electrode structure using hot phosphoric acid solution, with the silicon oxide film 13 as a mask. The barrier insulating film 12 is left on the element isolation insulating film 4 adjacent to the contact formation region.

Next, an interlayer insulating film (not shown) is formed all over the surface above the substrate 2. Then, a contact hole (not shown) is made in the interlayer insulating film. Following that, the contact hole is filled with conductive material, thereby forming a contact (not shown) made of the conductive material within the contact hole. This completes a semiconductor device according to the second embodiment.

As in the semiconductor device according to the first embodiment, in the semiconductor device manufactured by the manufacturing method of the second embodiment, because the barrier insulating film 12 has not been formed in the vicinity of the gate electrode structure, even if data is written and deleted repeatedly, part of the diffused layer 9 will not turn to a depletion layer. As a result, the drain current (on current) in the transistor is prevented from reducing, which prevents a decrease in the reliability as much as possible.

### (Third Embodiment)

A third embodiment of the present invention relates to a NAND cell EEPROM.

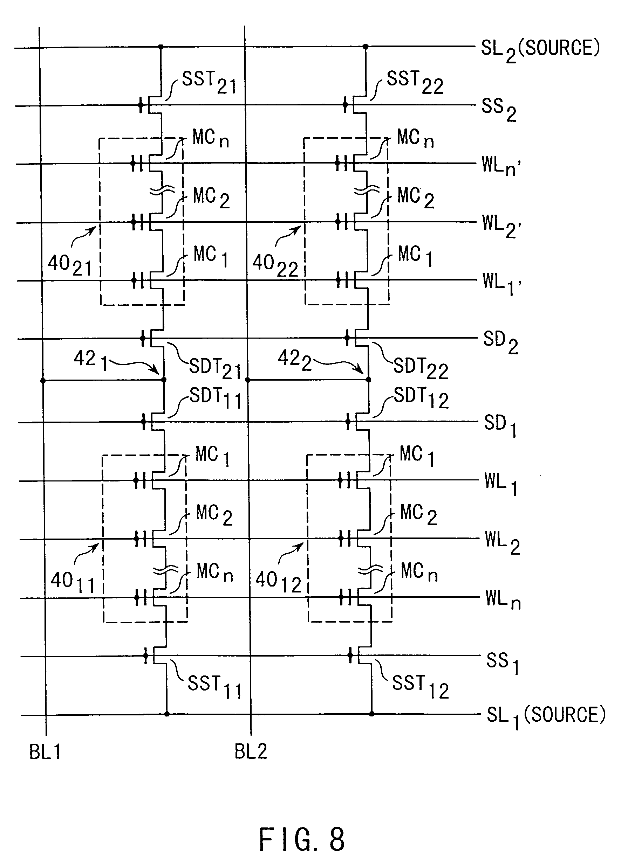

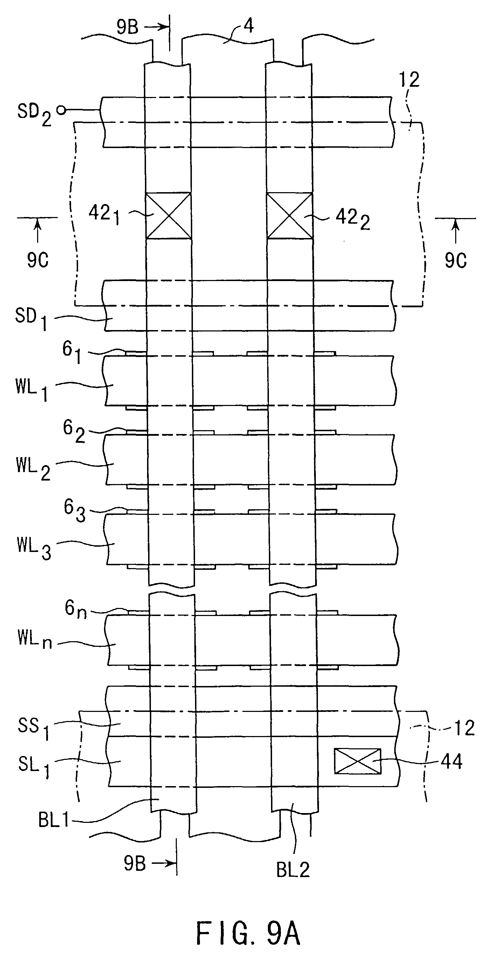

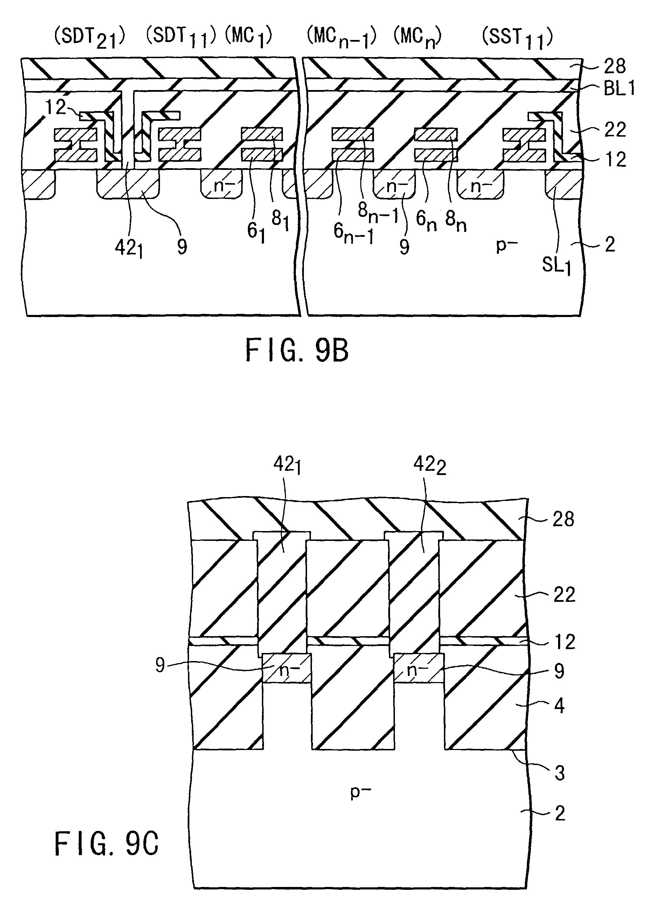

FIG. 8 is an equivalent circuit diagram of a NAND cell EEPROM, FIG. 9A is a plan view of a NAND cell EEPROM according to the third embodiment, FIG. 9B is a sectional view taken along line 9B-9B of FIG. 9A, and FIG. 9C is a sectional view taken along line 9C-9C of FIG. 9A.

As shown in FIG. 8, the NAND cell EEPROM has plural NAND cells 40₁₁, 40₁₂, 40₂₁, 40₂₂ arranged in a matrix on a substrate. Each NAND cell 40ᵢⱼ (i = 1, 2, j = 1, 2) has plural memory cells MC₁, MC₂, .., MCₙ. Each memory cell MCᵢ (i = 1, ..., n) is composed of a transistor having a gate electrode structure (or a stacked structure) where a gate insulating film, a floating gate 6ᵢ (i = 1, ..., n), a gate-to-gate insulating film, and a control gate 8ᵢ (i = 1, ..., n) are stacked one on top of another in that order (see FIGS. 8 and 9B). The plural memory cells MC₁, ..., MCₙ in each NAND cell 40ᵢⱼ are connected in series in such a manner that the adjacent ones of the memory cells share a source/drain region (diffused layer) 9.

Each NAND cell 40ᵢⱼ has the drain at one end connected via a select transistor SDTᵢⱼ (i = 1, 2, j= 1, 2) to a bit line BLⱼ (j = 1,2) and the source at the other end connected via a select transistor SSTᵢⱼ (i = 1, 2, j= 1, 2) to a source line BLⱼ (j = 1,2). The source line SLj takes the form of diffused layer wires as shown in FIG. 9B (see FIGS. 9A and 9B).

The sources of the select transistors SDT₁ⱼ, SDT₂ⱼ (i = 1, 2) connected to the NAND cells 40₁ⱼ, 40₂ⱼ (j = 1, 2) arranged in the direction of column are connected via a bit line contact 42j (j = 1, 2) to a bit line BLj (see FIG. 9C).

The control gate of a memory cell MCₖ (k = 1, ..., n) of the NAND cells 40ᵢ₁, 40ᵢ₂ (i = 1, 2) arranged in the direction of row perpendicular to the direction of column is connected to a word line WLₖ (k = 1, ..., n).

The gates of the select transistors SDT₁₁, SDT₁₂ are connected to a select line SD₁ and the gates of the select transistors SDT₂₁, SDT₂₂ are connected to a select line SD₂ (see FIG. 8).

The gates of the select transistors SST₁₁, SST₁₂ are connected to a select line SS₁ and the gates of the select transistors SST₂₁, SST₂₂ are connected to a select line SS₂ (see FIG. 8).

In the EEPROM according to the third embodiment, as shown in FIGS. 9A to 9C, a barrier insulating film 12 made of silicon nitride has been formed on the element isolating region 4 adjacent to the contact formation region (the diffused layer of the select transistor) in which contacts 42₁, 42₂ are to be made. The barrier insulating film 12 has not been formed on each NAND cell 40ᵢⱼ, with the gates of the select transistors STDᵢⱼ, SSTᵢⱼ as a boundary.

Each NAND cell 40ᵢⱼ, select transistors STDᵢⱼ, SSTᵢⱼ, and barrier insulating film 12 are covered with an interlayer insulating film 22. On the interlayer insulating film 22, a bit line BLᵢ is formed. The bit line BLi is covered with an interlayer film 28.

In the NAND cell EEPRON of the third embodiment, the barrier insulating film 12 has been formed on the element isolating region 4 adjacent to the region (the diffused layer of a select transistor) in which contacts 42₁, 42₂ are to be made. As a result, the contacts 42₁, 42₂ are prevented from coming into contact with the silicon substrate 2.

The barrier insulating film 12 has not been formed on each NAND cell 40ᵢⱼ. Specifically, because the barrier insulating film 12 has not been formed in the vicinity of the gate electrode structure of a memory cell MCₖ, even if data is written and deleted repeatedly, part of the diffused layer 9 will not turn to a depletion layer. As a result, the drain current (on current) in the memory cell is prevented from reducing, which prevents a decrease in the reliability as much as possible.

The barrier insulating film 12 has been formed in the vicinity of the gate electrode structure of each of the select transistors SDTᵢⱼ, SSTᵢⱼ.

However, a high voltage is not applied to these select transistors SDTᵢⱼ, SSTᵢⱼ when data is written and deleted. Therefore, it is unlikely that electrons are injected into the barrier insulating film 12 in the vicinity of the gate electrode structure of each of the select transistors SDTᵢⱼ, SSTᵢⱼ. Consequently, even if the barrier insulating film 12 is present in the vicinity of the select transistors SDTᵢⱼ, SSTᵢⱼ, the problem of the decrease of the drain current (on current) will not arise.

### (Fourth Embodiment)

A fourth embodiment of the present invention relates to an AND cell EEPROM.

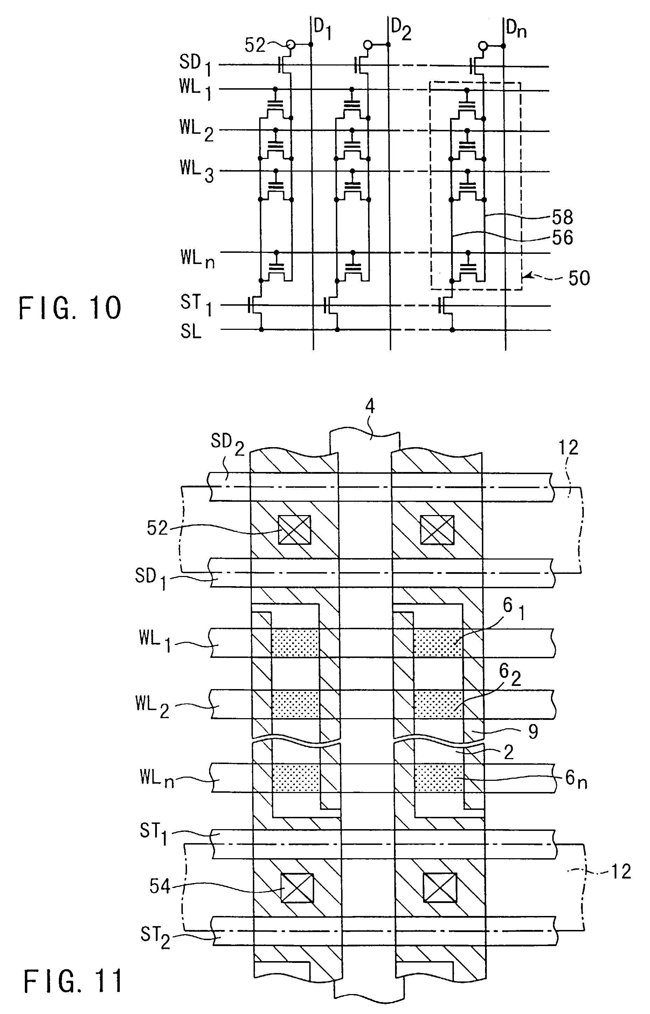

FIG. 10 is an equivalent circuit diagram of an AND cell EEPROM. FIG. 11 is a plan view of an AND cell EEPROM according to the fourth embodiment.

As shown in FIG. 10, an AND cell EEPROM has plural AND cells 50 arranged in a matrix on a substrate. Each AND cell has plural memory cells MC. Each memory cell is composed of a transistor having a gate electrode structure (stacked structure) where a gate insulating film, a floating gate, a gate-to-gate insulating film, and a control gate are stacked one on top of another in that order on the substrate. One end of each of the plural memory cells in each AND cell 50 is connected to a local source line 56 and the other end of each of them is connected to a local data line 58. The local source line 56 is connected via a select transistor to a common source line SL and the local data line 58 is connected via a select transistor to a global data line (also called a bit line) Dᵢ (i = 1, 2, ..., n). The select transistor connected to the local data line 58 is connected via a contact hole 52 to the corresponding global data line Di.

The control gates of the memory cells MC in the AND cells 50 arranged in the direction of row are connected to the corresponding word lines WLᵢ (i = 1, ..., n).

The gate of the select transistor connected to the local source line 56 is connected to a select line ST₁ and the gate of the select transistor connected to the local data line 58 is connected to a select line SD₁.

In FIG. 8, only AND cells 50 arranged in the direction of row are shown. Actually, however, other AND cells sharing contacts 52 and other AND cells sharing common source lines SL are also arranged in the direction of column.

In FIG. 11, reference symbol 2 indicates a semiconductor substrate and reference symbols 6₁, ..., 6ₙ indicate floating gates.

In the AND cell EEPROM of the fourth embodiment, as shown in FIG. 9, the barrier insulating film 12 has been formed on the element isolating region 4 adjacent to the region (the diffused layer of a select transistor) in which a contact 52 with the global data line Dᵢ is to be formed and on the element isolating region 4 adjacent to the region (the diffused layer of a select transistor) in which a contact 54 with the common source line SL is to be formed. This prevents the contacts 52, 54 from coming into contact with the silicon substrate 2.

The barrier insulating film 12 has not been formed on each AND cell 50. Specifically, because the barrier insulating film 12 has not been formed in the vicinity of the gate electrode structure of each memory cell MC, even if data is written and deleted repeatedly, part of the diffused layer 9 will not turn to a depletion layer. As a result, the drain current (on current) in the memory cell is prevented from reducing, which prevents a decrease in the reliability as much as possible.

### (Fifth Embodiment)

A fifth embodiment of the present invention relates to a method of manufacturing NAND cell EEPROMs.

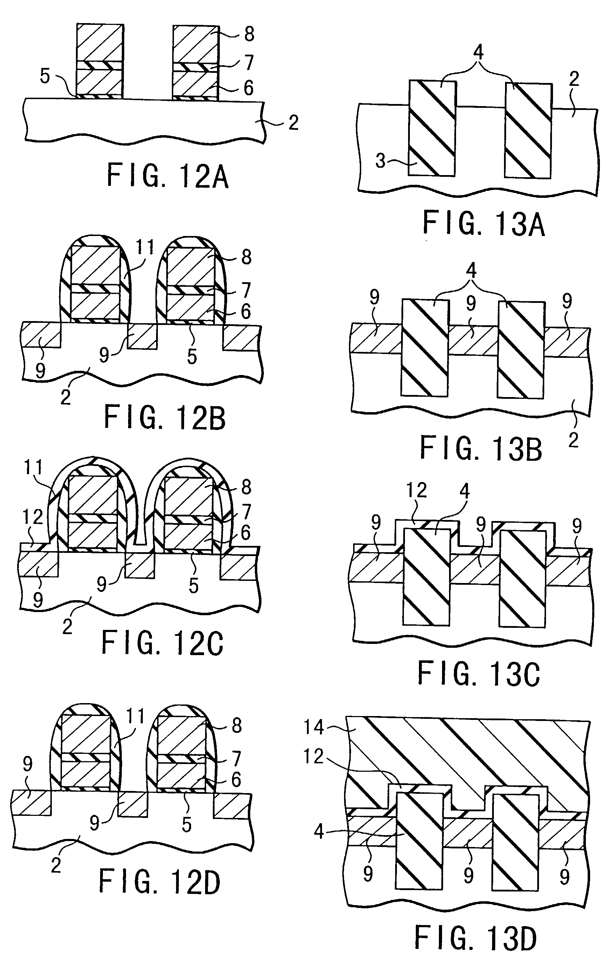

FIGS. 12A to 12G and FIGS. 13A to 13G are sectional views showing manufacturing processes to help explain a method of manufacturing a NAND cell EEPROM according to the fifth embodiment. FIGS. 12A to 12G are sectional views corresponding to the sectional view taken along line 9B-9B of FIG. 9A and FIGS. 13A to 13G are sectional views corresponding to the sectional view taken along line 9C-9C of FIG. 9A.

First, as shown in FIGS. 12A and 13A, a shallow trench 3 is formed in a region where an element isolating region is to be formed in, for example, a p-type silicon substrate 2. Then, the shallow trench 3 is filled with an element isolation insulating film 4 made of silicon oxide. Following that, a gate insulating film 5, a conductive film 6 to act as a floating gate, an insulating film 7, and a conductive film 8 to act as a control gate are stacked one on top of another in that order on the entire surface of the substrate 2. Patterning these films produces a gate electrode structure.

Next, as shown in FIGS. 12B and 13B, for example, silicon oxide is deposited on the p-type silicon substrate by CVD techniques. Then, the insulating film 11 is etched back by RIE techniques, thereby forming a sidewall made of the insulating film 11 on the side of the gate electrode structure. At this time, the insulating film 11 also remains on the gate electrode structure.

Then, as shown in FIGS. 12C and 13C, using the gate electrode structure, insulating film 11, and element isolation insulating film 4 as a mask, impurity ions are implanted into the element region of the substrate 2, thereby forming a diffused layer 9 for a source and a drain. Following that, silicon nitride is deposited all over the surface above the substrate 2 using CVD techniques, thereby forming a barrier insulating film 12.

Then, as shown in FIGS. 12D and 13D, a resist pattern 14 which is made of photoresist and covers the contact formation region and only the element isolation insulating film 4 adjacent to the region is formed on the barrier insulating film 12. Then, with the resist pattern 14 as a mask, the barrier insulating film 12 is etched using CDE (chemical Dry Etching) techniques.

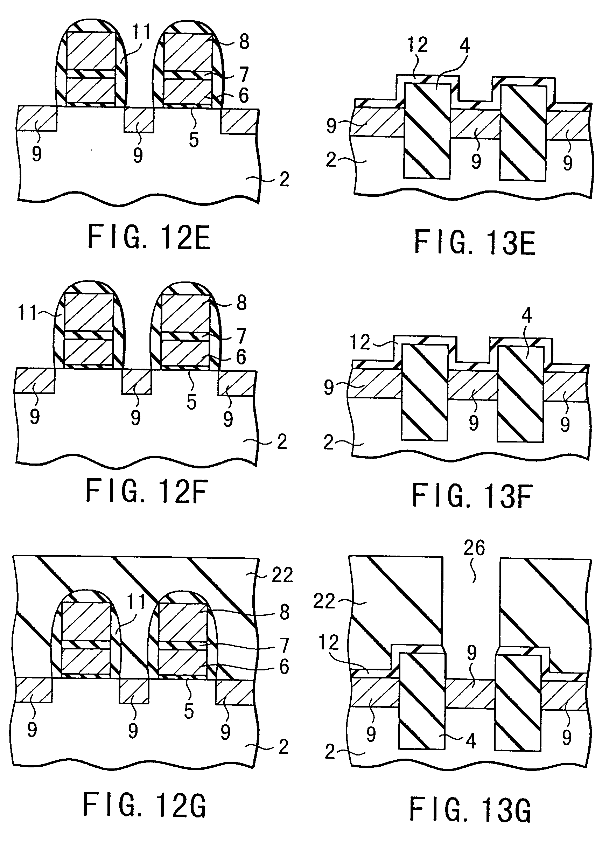

Next, as shown in FIGS. 12E and 13E, after the resist pattern 14 has been removed, annealing is done to improve the quality of the insulating film 11. At this time, the diffused layer 9 extends as far as under the sidewall made of the insulating film 11.

Next, as shown in FIGS. 12F and 13F, annealing is done to activate the diffused layer 9. At this time, the diffused layer 9 extends as far as under the gate electrode structure.

Next, as shown in FIGS. 12G and 13G, an interlayer insulating film 22 is formed all over the surface above the substrate 2. Then, a contact hole 26 is made in the interlayer insulating film 22. Following that, the contact hole is filled with conductive material, thereby forming a contact (not shown) made of the contact material within the contact hole.

With the manufacturing method of the fifth embodiment, the barrier insulating film 12 is formed only on the contact formation region and the element isolation insulating film 4 adjacent to the region. Specifically, the barrier insulating film 12 has not been formed in the vicinity of the gate electrode structure of each memory cell. Therefore, even if data is written and deleted repeatedly, part of the diffused layer 9 will not turn to a depletion layer. As a result, the drain current (on current) in the transistor is prevented from reducing, which prevents a decrease in the reliability as much as possible.

Furthermore, since the barrier insulating film 12 has been formed on the contact formation region and the element isolation insulating film 4 adjacent to the region, the contact 26 will not penetrate to the substrate 2.

Additionally, since impurity ions have been implanted into the element region of the substrate 2, with the sidewall made of the insulating film 11 as a mask, the diffused layer 9 for the source and drain is less liable to extend as far as under the gate electrode structure, even when annealing is done to improve the quality of the sidewall made of the insulating film 11 and another annealing is done to activate the diffused layer. As a result, the short channel effect in the transistor can be suppressed.

### (Sixth Embodiment)

A sixth embodiment of the present invention relates to a method of manufacturing NAND cell EEPROMs.

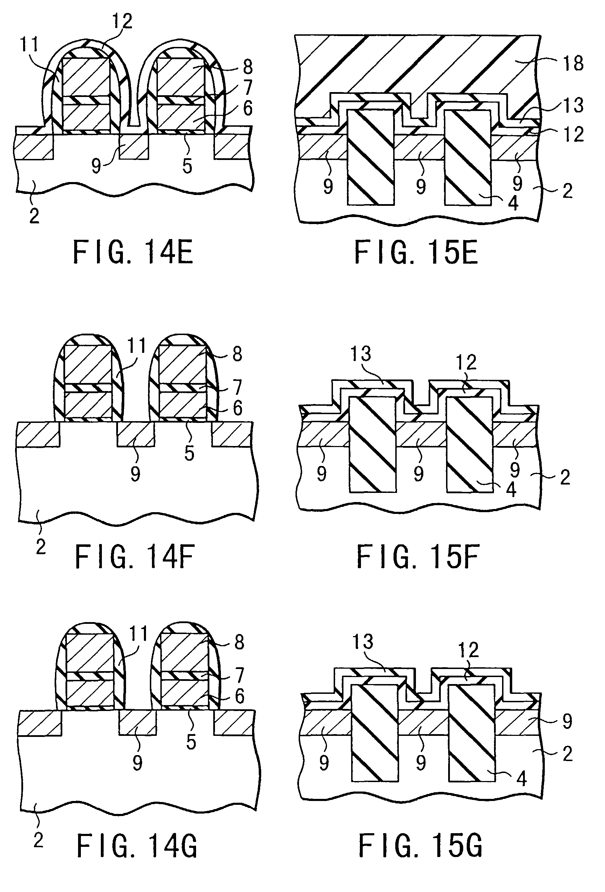

FIGS. 14A to 14G and FIGS. 15A to 15G are sectional views showing manufacturing processes to help explain a method of manufacturing a NAND cell EEPROM according to the sixth embodiment. FIGS. 14A to 14G are sectional views corresponding to the sectional view taken along line 9B-9B of FIG. 9A and FIGS. 15A to 15G are sectional views corresponding to the sectional view taken along line 9C-9C of FIG. 9A.

First, as shown in FIGS. 14A and 15A, a shallow trench 3 is formed in a region where an element isolating region is to be formed in, for example, a p-type silicon substrate 2. Then, the shallow trench 3 is filled with an element isolation insulating film 4 made of silicon oxide. Following that, a gate insulating film 5, a conductive film 6 to act as a floating gate, an insulating film 7, and a conductive film 8 to act as a control gate are stacked one on top of another in that order on the entire surface of the substrate 2. Patterning these films produces a gate electrode structure. Next, using CVD techniques, for example, silicon oxide is deposited only on the element region of the p-type silicon substrate 2, thereby forming an insulating film 11. Then, the insulating film 11 is etched back by RIE techniques, thereby forming a sidewall made of the insulating film 11 on the side of the gate electrode structure. At this time, the insulating film 11 also remains on the gate electrode structure.

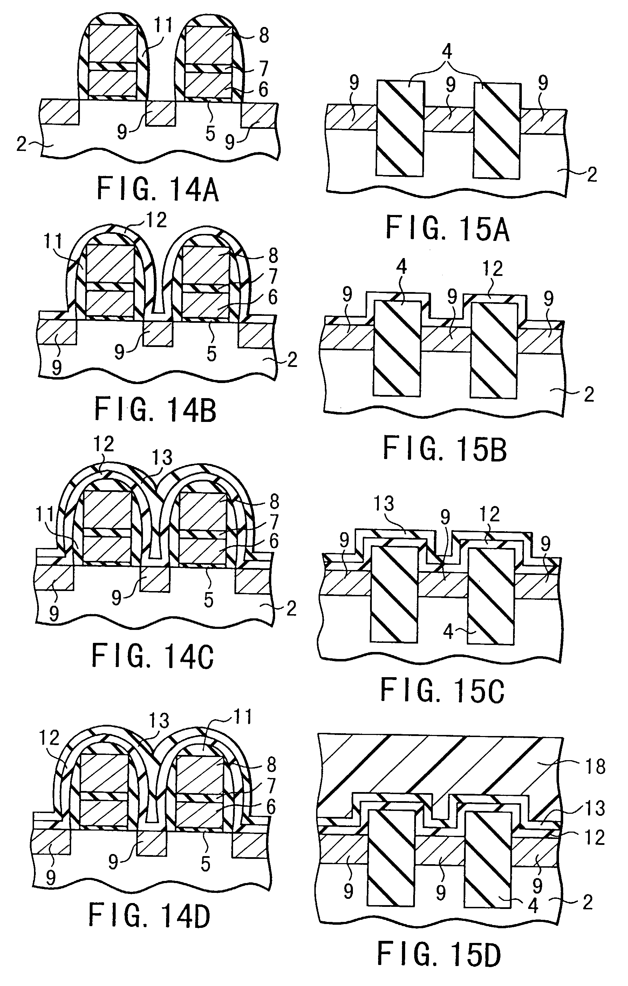

Then, as shown in FIGS. 14B and 15B, using the gate electrode structure, insulating film 11, and element isolation insulating film 4 as a mask, impurity ions are implanted into the element region of the substrate 2, thereby forming a diffused layer 9 for a source and a drain. Following that, silicon nitride is deposited all over the surface above the substrate using CVD techniques, thereby forming a barrier insulating film 12.

Then, as shown in FIGS. 14C and 15C, on the barrier insulating film 12, for example, silicon oxide is deposited using CVD techniques, thereby forming an insulating film 13.

Next, as shown in FIGS. 14D and 15D, a resist pattern 18 which is made of photoresist and covers only the contact formation region and the element isolation insulating film 4 adjacent to the region is formed on the insulating film 13. Then, with the resist pattern 18 as a mask, the insulating film 13 is etched using wet etching techniques.

Next, as shown in FIGS. 14E and 15E, after the resist pattern 18 has been removed, the barrier insulating film 12 is etched with the insulating film 13 as a mask, using wet etching with the selectivity of the insulating film 13 to the barrier insulating film 12.

Next, as shown in FIGS. 14F and 15F, annealing is done to activate the diffused layer 9. At this time, the diffused layer 9 extends as far as under the gate electrode structure.

The manufacturing method of the sixth embodiment produces a similar effect to that of the manufacturing method of the fifth embodiment.

As explained above, with the first to sixth embodiments, it is possible to provide a semiconductor device capable of preventing a decrease in the reliability as much as possible.

### (Seventh Embodiment)

A seventh embodiment of the present invention relates to a NAND cell EEPROM with a booster plate.

Before explanation of the seventh embodiment, the configuration and operation of a NAND cell EEPROM and a NAND cell EEPROM with a booster plate will be described.

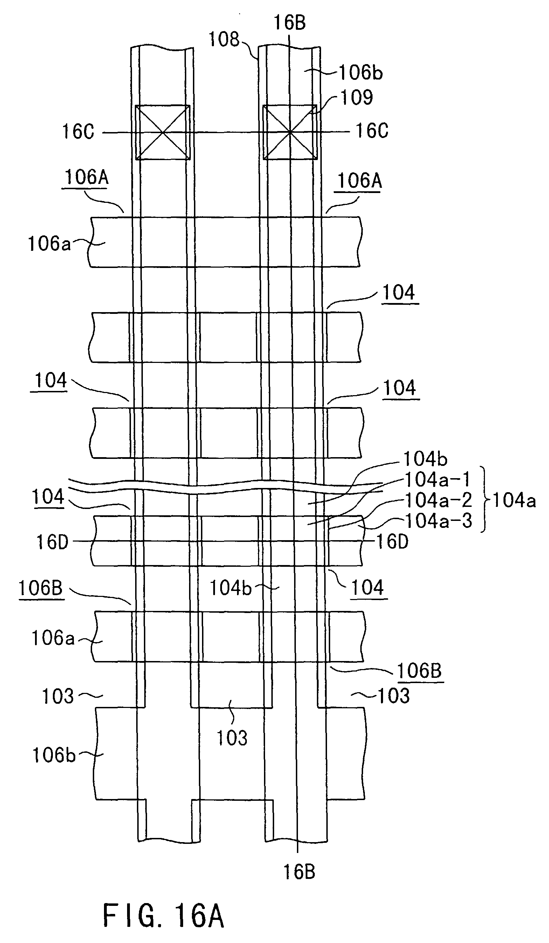

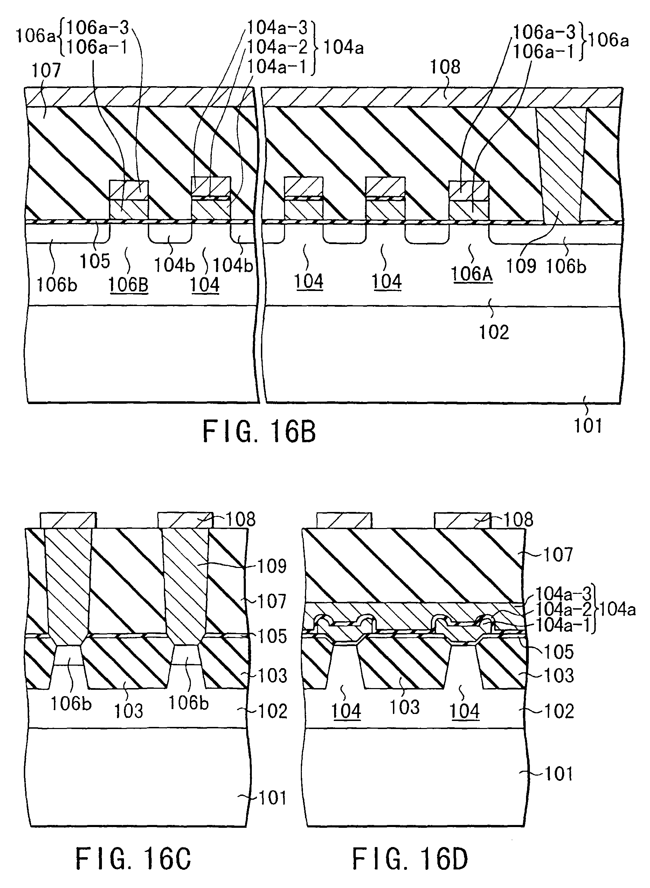

FIGS. 16A to 16D schematically show the configuration of a memory cell array in a conventional NAND EEPROM. FIG. 16A is a plan view showing the internal structure, FIG. 16B is a sectional view taken along line 16B-16B of FIG. 16A, FIG. 16C is a sectional view taken along line 16C-16C of FIG. 16A, and FIG. 16D is a sectional view taken along line 16D-16D of FIG. 16A.

In the memory cell array, for example, a well region 102 is provided at the main surface of a semiconductor substrate 101. At the surface of the well region 102, STI-structure element isolating regions 103 are formed in such a manner that part of the element isolating regions 103 are selectively projected above the main surface of the semiconductor substrate 101. On the element region delimited in stripes by the STI-structure element isolating regions 103, MOS transistors (memory cells 104) of a stacked gate structure are arranged in a matrix.

Each of the memory cells 104 is composed of a gate electrode section 104a selectively provided on a thin oxide film (tunnel oxide film) 105 at the surface of the well region 102 and a diffused layer region 104b that is to act as a drain or a source and provided at the surface of the well region 102 corresponding to the space between the gate electrode sections 104a. Each diffused layer region 104b is shared by other memory cells 104 adjacent to each other in the direction of column line, for example, bit line (BL). Plural memory cells are connected in series, thereby forming a single NAND cell (memory cell unit).

Each of the gate electrode sections 104a is composed of a structure where a floating gate 104a-1 acting as a charge storage layer, a gate-to-gate insulating film 104a-2, and a control gate 104a-3 stacked in that order on the channel region between the diffused layer regions 104b. The control gate 104a-3 is shared by, for example, other gate electrode section 104a in the direction of row line and functions as a word line (WL).

Select gate (SG) transistors (a drain-side select gate 106A and a source-side select gate 106B) are provided at, for example, both ends of the NAND cell in the direction of bit line.

The drain-side select gate 106A is composed of a gate electrode 106a provided on the tunnel oxide film 105 and a diffused layer region 106b adjacent to the gate electrode 106a, provided at the surface of the well region 102, and acting as a drain. A diffused layer region acting as a source is shared by the memory cells 104 at the ends adjacent to the drain-side select gate 106A.

The source-side select gate 106B is composed of a gate electrode 106a provided on the tunnel oxide film 105 and a diffused layer region 106b adjacent to the gate electrode 106a, provided at the surface of the well region 102 so as to be shared by other source-side select gates 106B adjacent to each other in the direction of row line, and acting as a source line (SL). A diffused layer region acting as a drain is shared by the memory cells 104 at the ends adjacent to the source-side select gate 106B.

In this case, each gate electrode 106a has a structure where a second gate 106a-3 made of the same material as that of the control gate 104a-3 is stacked on a first gate 106a-1 made of the same material as that of the floating gate 104a-1. Each gate electrode 106a is shared by, for example, other select gates 106A and 106B in the direction of row line.

On the other hand, an interlayer insulating film 107 is provided on the main surface of the semiconductor substrate 101 in such a manner that the memory cells 104 and select gates 106A and 106B are covered with the interlayer insulating film 107.

On the top surface of the interlayer insulating film 107, bit lines 108 are provided in the direction of the column of the memory cells 104. Each bit line 108 is connected to the diffused layer region 106b of the drain-side select gate 106A by a bit-line contact 109 provided so as to penetrate through the interlayer insulating film 107 and tunnel oxide film 105.

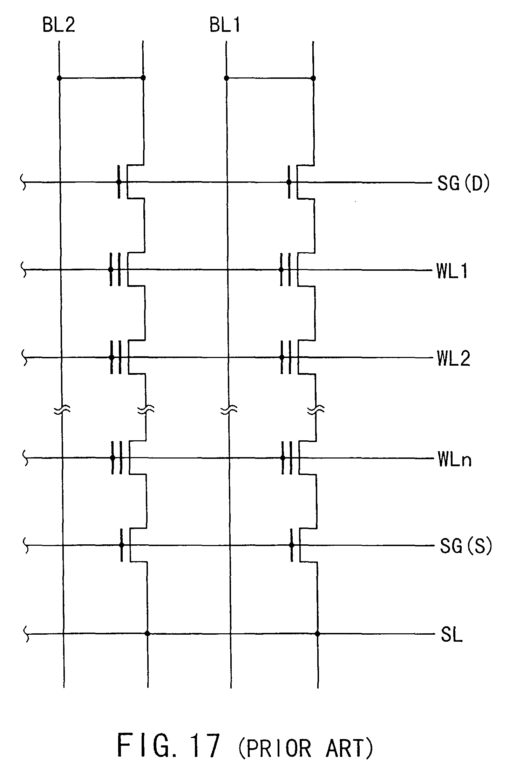

FIG. 17 is an equivalent circuit diagram of a memory cell array of the above-described structure.

Data is written into, erased from, and read from the memory cell array by making use of an exchange of electrons between the floating gate 104a-1 and well region 102 under the potential relationship shown in

**Table 1**

| | Program | Erase | Read |
|---|---|---|---|
| BL1 (selected) | 0 | floating | 1V |
| BL2 (unselected) | Vcc | floating | 0 |
| SG (D) | Vcc | floating | Vread |
| WL2 (selected) | Vppw | 0 | 0 |
| WL1, 3 ... n (unselected) | Vpass | floating | Vread |
| SG (S) | 0 | floating | Vread |
| SL | 0 | floating | 0 |
| Well | 0 | Vppe | 0 |

The basic operation of a general NAND EEPROM will be explained.

When data is written, a high potential Vppw (e.g., 20V) is applied to the control gate and 0V is applied to the drain, source, and well region. Then, passing current into the tunnel oxide film causes electrons to be injected from the well region into the floating gate by a tunnel phenomenon. Then, the threshold voltage of the transistor in the memory cell goes positive, thereby writing the data.

Usually, in a NAND EEPROM, the data is written simultaneously into all the transistors (memory cells) connected to the selected control gate. At this time, 0V is applied to the bit line to which the selected cell (the memory cell into which the data is to be written) is connected and Vcc (e.g., 3V) is applied to the bit line to which the unselected cells (the memory cells into which the data is not written) are connected.

Then, Vcc is applied to the select gate on the drain side and a potential of Vpass (e.g., 10V) is applied to the control gates of the unselected cells so that 0V is transferred to the selected cell.

In this state, the high voltage Vppw (e.g., 20V) is applied to the control gates. Then, in the selected cell, Vppw is applied to the control gate and 0V is applied to the well region, thereby selectively writing the data.

On the other hand, the drain-side select gates of the unselected cells are cut off, because Vcc is applied to the bit line. The source-side select gates are also cut off, because 0V is applied to the source lines and to the gates. As a result, all the memory cells connected to the bit line go into the floating state.

In this state, when a specific voltage is applied to the control gate, the channel potential at the unselected cells rises by capacitive coupling, decreasing the voltage applied between the gate and channel, which prevents the data from being written.

When the data is erased, 0V is applied to the control gate and a high potential of Vppe (e.g., 20V) is applied to the well region, thereby releasing electrons from the floating gate into the well region. Then, the threshold voltage of the transistor goes negative. Although not shown in Table 1, erasing is generally done in such a manner that all of the selected block is erased from.

Reading is done by making use of the positive and negative threshold voltages of the transistor in the memory cell. For example, 1V is applied to the selected bit line and 0V is applied to the selected control gate, and the data is judged, depending on whether current flows in the transistor or not. At this time, a read potential of Vread (e.g., 5V) is applied so that all of the control gates and select gates of the unselected cells may turn on.

In the case of such an EEPROM, it is known that if the channel potential of the unselected cell in a write operation does not rise sufficiently, the voltage between the gate of the unselected cell and the channel will go high, leading to erroneous writing.

To overcome this problem, a memory cell array with a booster plate has been proposed.

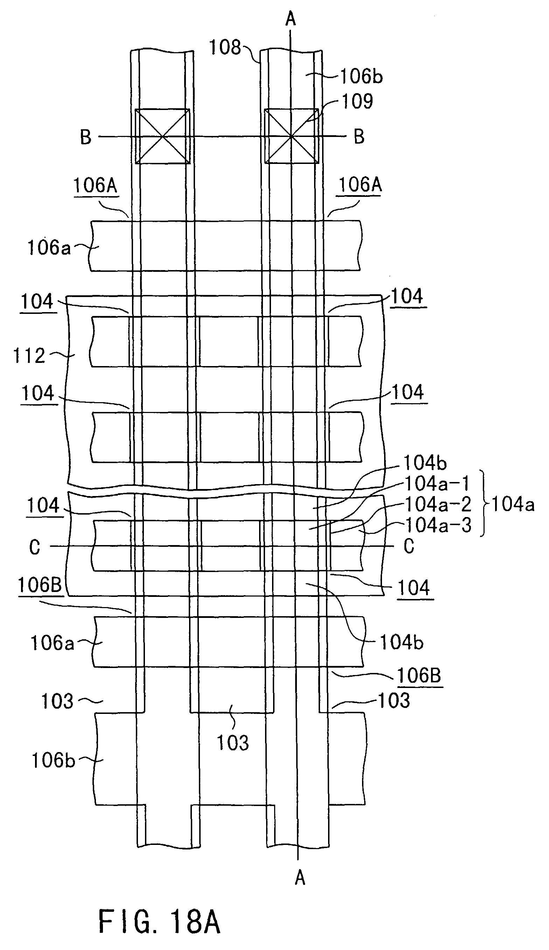

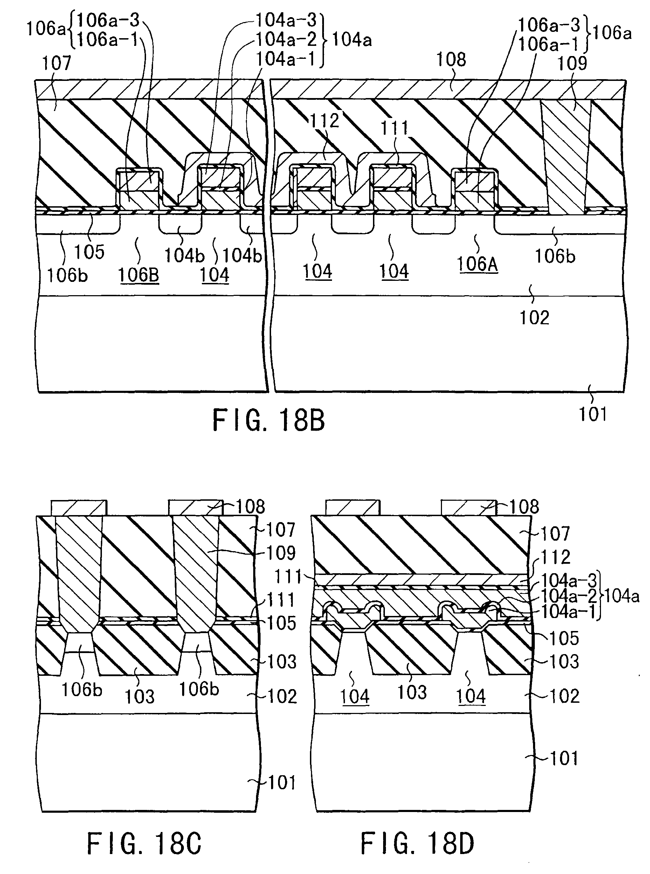

FIGS. 18A to 18D schematically show the configuration of a conventional memory cell array with a booster plate in a NAND EEPROM. FIG. 18A is a plan view showing the internal structure, FIG. 18B is a sectional view taken along line 18B-18B of FIG. 18A, FIG. 18C is a sectional view taken along line 18C-18C of FIG. 18A, and FIG. 18D is a sectional view taken along line 18A-18A of FIG. 18A.

In the memory cell array, for example, a booster plate 112 made of conductive material is provided so as to cover the gate electrode section 104a of the memory cell 104 via a plate insulating film 111.

In this case, when the data is written, the high voltage Vppw is also applied to the booster plate 112, thereby increasing the substantial capacitive coupling ratio, which not only enables the channel potential at the unselected cells in a write operation to rise sufficiently, but also makes the high voltage Vppw (about 14V) applied to the control gate lower than when the booster plate 112 is not used.

Even in a memory cell array where use of the booster plate 112 prevents the data from being written erroneously due to an increase in the voltage between the gates of the unselected gates and the channels, the following problem arises: a faulty operation is liable to occur due to the processes in making a contact hole to form a bit line contact 109.

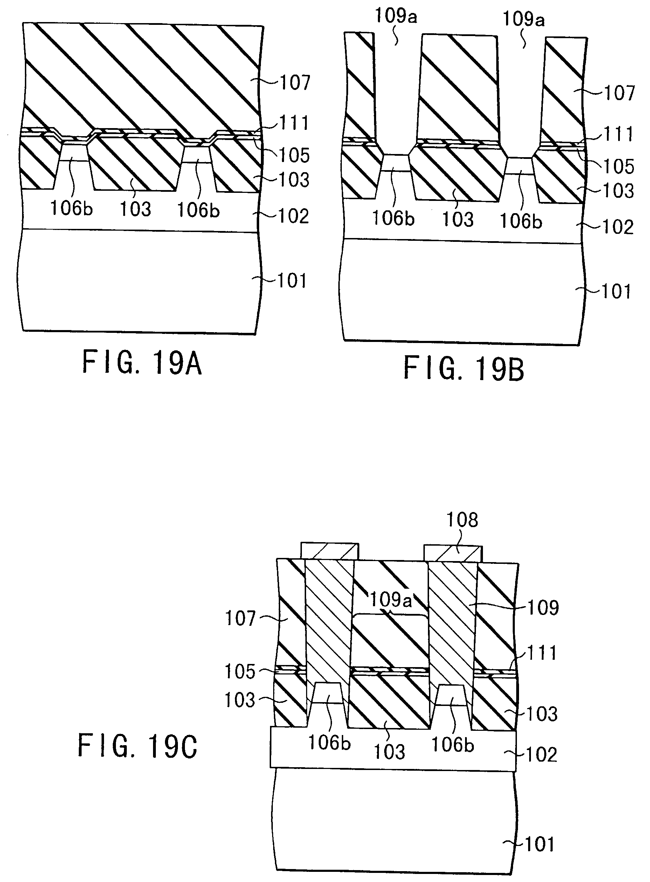

Specifically, in the conventional memory cell array, when the bit line contact 109 is formed, the interlayer insulating film 107 and the plate insulating film 111 and tunnel oxide film 105 under the interlayer insulating film 107 are removed consecutively by reactive ion etching or the like, thereby making the contact hole 109a leading to the diffused layer region 106b of the drain-side select gate 106A, as shown in FIGS. 19A and 19B. At that time, the reactive ion etching is controlled in such a manner that the etching is stopped when the diffused layer region 106b is exposed.

Etching to make the contact hole 109a is generally done somewhat excessively. The reason for this is to absorb variations in the processes, including the film thickness of the interlayer insulating film 107 and the etching speed. Even in the worst case, etching has to be effected until the surface of the element region has certainly been exposed.

Therefore, if the interlayer insulating film 107 is thinner than expected or the etching speed is faster than expected, etching will be done excessively at the bottom surface of the contact hole 109a as shown in FIG. 19C, with the result that an excess portion is also etched.

This is because a silicon oxide insulating material, the same as that of the interlayer insulating film 107, is used in forming the element isolating region (or embedding an STI). Thus, as a result of excess etching, the element isolating region 103 is etched at the same time.

Since the etching speed and the thickness of the interlayer insulating film 107 vary in the same wafer or from one wafer to another in terms of processes, it is actually difficult to stop etching suitably at the time when the element region has been exposed and there is a strong possibility that the element isolating region 103 will also be etched. If the contact hole 109a has reached the bottom surface of the element isolating region 103, the effective distance between adjacent bit line contacts 109 becomes shorter, permitting punch-through to occur between bit lines, which contributes to faulty operations.

Such a problem arises not only in a memory cell array using the element isolating region 103 of an STI structure but also in a memory cell array using an element isolating oxide film formed by selective oxidation (LOCOS) techniques.

If, in order to overcome such a problem, the diameter of the contact hole 109a were made smaller to prevent the element isolating region 103 from being etched, it would be difficult to effect patterning in the photolithographic process or the aspect ratio of the contact hole 109a would increase, making the etching and the embedding of conductive material difficult. Conversely, if the width of the element region were increased, the area of the memory cell array would increase. This is undesirable.

As described above, there has been the following problem: a faulty operation is liable to occur, depending on the accuracy of work in making the contact hole 109a, which decreases the reliability. This problem becomes worse, as the memory cell array is miniaturized more.

Accordingly, the object of the seventh embodiment is to provide a nonvolatile semiconductor memory device capable of preventing a faulty operation resulting from the accuracy of work in making a contact hole and improving the characteristic and reliability of the device and a method of manufacturing the nonvolatile semiconductor memory device.

Hereinafter, an EEPROM with a booster plate according to the seventh embodiment will be explained in detail.

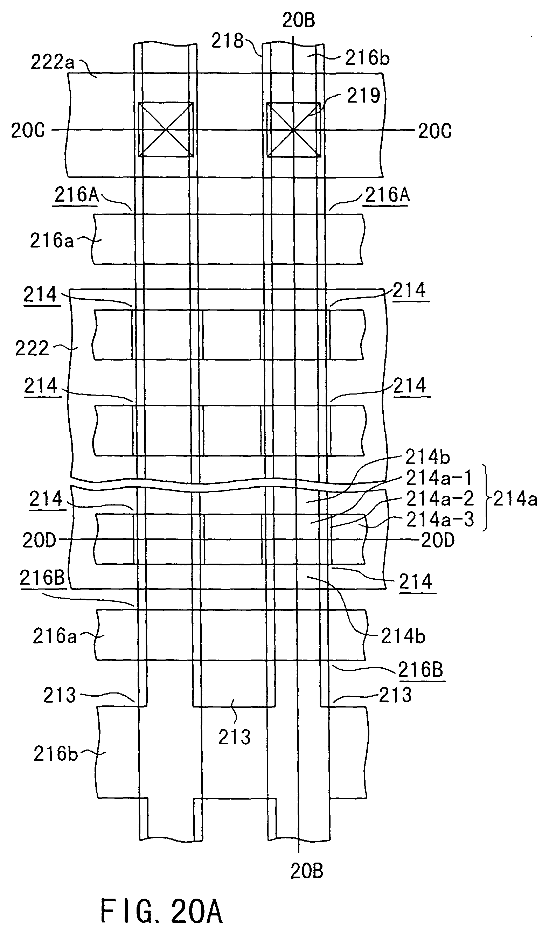

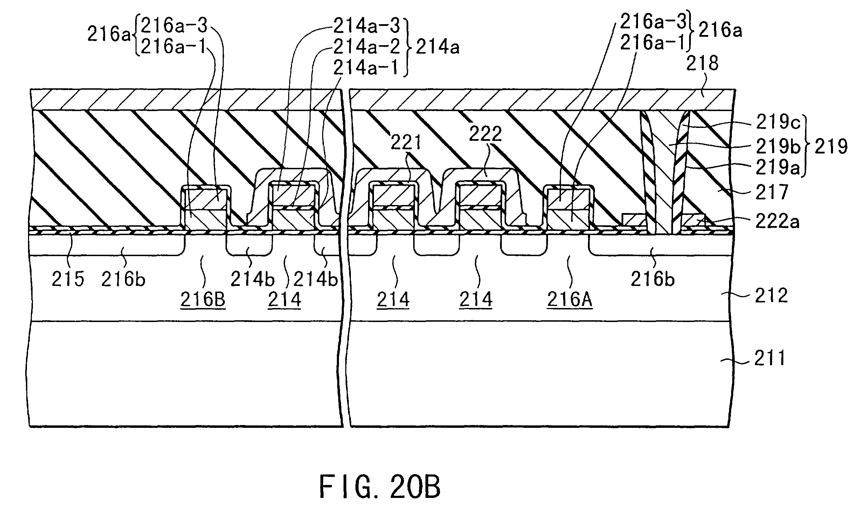

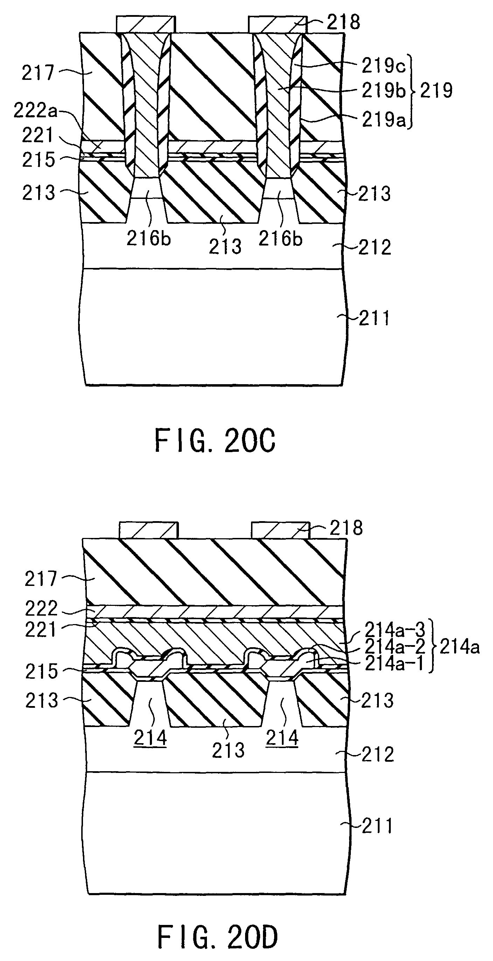

FIGS. 20A to 20D schematically show the configuration of a nonvolatile semiconductor memory according to the seventh embodiment in, for example, a memory cell array of a NAND EEPROM. FIG. 20A is a plan view showing the internal structure, FIG. 20B is a sectional view taken along line 20B-20B of FIG. 20A, FIG. 20C is a sectional view taken along line 20C-20C of FIG. 20A, and FIG. 20D is a sectional view taken along line 20D-20D of FIG. 20A.

In the memory cell array, for example, a well region 212 is provided at the main surface of a semiconductor substrate 211. At the surface of the well region 212, STI-structure element isolating regions (element isolation insulating films) 213 are formed in such a manner that part of the element isolating regions 103 are selectively projected above the main surface of the semiconductor substrate 211. On the element region delimited in stripes by the element isolating regions 213, MOS transistors (memory cells 214) of a stacked gate structure are arranged in a matrix.

Each of the memory cells 214 is composed of a gate electrode section 214a selectively provided on a thin tunnel oxide film (gate insulating film) 215 at the surface of the well region 212 and a diffused layer region 214b that acts as a drain or a source and is provided at the surface of the well region 212 corresponding to the space between the gate electrode sections 214a.

The tunnel oxide film 215 is composed of about 10-nm-thick silicon oxide film, silicon nitride film, or silicon oxynitride film, or a stacked film of those films.

Each of the diffused layer regions 214b is formed by ion-implanting or thermally diffusing impurities of the opposite conductivity to that of the well region 212. Each diffused layer region 214b is shared by other memory cells 214 adjacent to each other in the direction of column line, for example, bit line (BL).

Each of the gate electrode sections 214a is composed of a structure where a floating gate 214a-1 acting as a charge storage layer, a gate-to-gate insulating film 214a-2, and a control gate 214a-3 stacked in that order on the channel region between the diffused layer regions 214b.

The floating gate 214a-1, which is made of, for example, polycrystalline silicon or amorphous silicon, is electrically isolated from the surrounding conductive layer by the tunnel oxide film 215 and gate-to-gate insulating film 214a-2.

The gate-to-gate insulating film 214a-2 is composed of a silicon oxide film, a silicon nitride film, or a silicon oxynitride film, or a stacked film of those films.

The control gate 214a-3, which is provided so as to cross the element region, is shared by, for example, other gate electrode sections 214a in the direction of row line and functions as a word line (WL).

In this case, plural (for example, 16) memory cells 14 are connected in series in the direction of bit line, thereby forming a NAND cell serving as a memory cell unit. At both ends of the series connection in the direction of each bit line, select gate (SG) transistors (a drain-side select gate (SG(D)) 216A and a source-side select gate (SG(SS)) 216B are provided.

Each drain-side select gate 216A is composed of a gate electrode 216a provided on the tunnel oxide film 215 and a diffused layer region 216b adjacent to the gate electrode 216a, provided at the surface of the well region 212, and acting as a drain. A diffused layer region acting as a source is shared by the memory cells 214 at the ends adjacent to the drain-side select gate 216A.

Each source-side select gate 216B is composed of a gate electrode 216a provided on the tunnel oxide film 215 and a diffused layer region 216b adjacent to the gate electrode 216a, provided at the surface of the well region 212 so as to be shared by other source-side select gates 216B adjacent to each other in the direction of row line, and acting as a source line (SL). A diffused layer region acting as a drain is shared by the memory cells 214 at the ends adjacent to the source-side select gate 216B.

In this case, each gate electrode 216a has a structure where a second gate 216a-3 made of the same material as that of the control gate 214a-3 is stacked on a first gate 216a-1 made of the same material as that of the floating gate 214a-1. Each gate electrode 216a, which is provided so as to cross the element region, is shared by, for example, other select gates 216A and 216B in the direction of row line.

On the other hand, a booster plate 222 is provided on the main surface of the semiconductor substrate 211 in such a manner that at least part of the gate electrode section 214a of each memory cell 204 is covered with the booster plate 222 via the plate insulating film 221.

The plate insulating film 221, which is provided so as to cover at least the main surface of the semiconductor substrate 211, is composed of, for example, a silicon oxide film, a silicon nitride film, or a silicon oxynitride film, or a stacked film of those films.

The booster plate 222 is composed of a polycrystalline silicon film (or a conductive layer of tungsten polycide or the like) whose resistance has been made lower by doping a lot of impurities. In addition to covering all of the memory cell 214 excluding the select gates 216A, 216B, the booster plate 222 may be provided so as to cover only part of the memory cell 214.

An etching stop layer (cover layer) 222a is provided integrally on the top surface of each diffused layer region 216b of the drain-side select gate 216A via the tunnel oxide film 215 and plate insulating film 221. The etching stop layer 222a is formed out of the polycrystalline silicon film whose resistance has been made lower by doping a lot of impurities and which constitutes the booster plate 222.

Furthermore, an interlayer insulating film 217 is provided on the main surface of the semiconductor substrate 211 in such a manner that the memory cell 214 and select gates 216A, 216B are covered with the interlayer insulating film 217.

On the top surface of the interlayer insulating film 217, bit lines 218 are arranged in the direction of column of the memory cells 214. Each bit line 218 is connected to the diffused layer region 216b of the drain-side select gate 216A by a bit line contact (contact section) 219.

Each bit line contact 219 is formed by filling a contact hole 219a with conductive filler (or conductive material) 219b. The contact hole 219a is made so as to penetrate through, for example, the interlayer insulating film 217, etching stop layer 222a, plate insulating film 221, and tunnel oxide film 215.

Each bit line contact 219 is electrically insulated in such a manner that a sidewall insulating film 219c is formed on the inner wall face of the contact hole 219a in contact with the etching stop layer 222a to prevent the bit line contacts 219 from being short-circuited to each other via the etching stop layer 22a.

The sidewall insulating film 219c is formed out of, for example, a silicon oxide film or a silicon nitride film. Polycrystalline silicon, amorphous silicon, or tungsten is used for the filler 219b.

Here, the operation of the memory cell array with the above-described structure will be explained briefly. Basically, the memory cell array operates similarly to a conventional memory cell array with a booster plate.

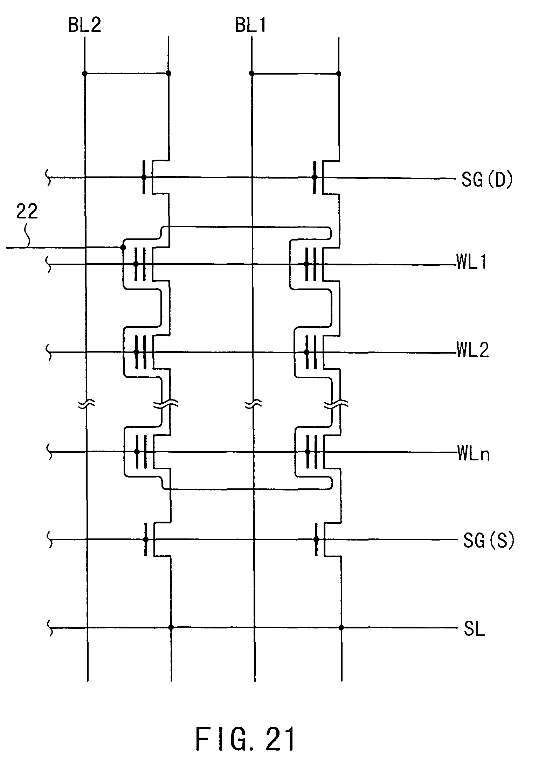

FIG. 21 is an equivalent circuit diagram of a memory cell array of the above-described structure.

Data is written into, erased from, and read from the memory cell array by making use of an exchange of electrons between the floating gate 214a-1 and well region 212 under the potential relationship shown in

**Table 2**

| | Program | Erase | Read |
|---|---|---|---|
| BL1 (selected) | 0 | floating | 1V |
| BL2 (unselected) | Vcc | floating | 0 |
| SG (D) | Vcc | floating | Vcc |
| Booster Plate | Vppw | 0 | Vcc |
| WL2 (selected) | Vppw | 0 | 0 |
| WL1, 3 ... n (unselected) | Vcc | floating | Vcc |
| SG (S) | 0 | floating | Vcc |
| SL | 0 | floating | 0 |
| Well | 0 | Vppe | 0 |

Specifically, when data is written, a high potential of Vppw (e.g., 214V) is applied to the control gate 214a-3 and booster plate 222 and 0V is applied to the diffused layer region (drain/source) 214b and well region 212. In this case, the booster plate 222 provided on the sidewall of the floating gate 214a-1 increases the substantial coupling ratio, which enables the voltage Vppw applied to the control gate 214a-3 to be lower than when the booster plate is not used.

When the data is deleted, 0V is applied to the control gate 214a-3 and booster plate 222 and a high potential of Vppe (e.g., 17V) is applied to the well region 212. In this case, too, the voltage Vppe applied to the control gate 214a-3 can be made lower than when the booster plate is not used.

When the data is read out, for example, 1V is applied to the selected bit line 218 and 0V is applied to the selected control gate 214a-3, thereby judging whether or not current flows in the transistor. At this time, a read potential of Vcc (e.g., 3V) is applied to the control gate 214a-3 of the unselected cell, select gates 216A, 216B, and booster plate 222 to turn on all the transistors except for the transistor in the selected cell.

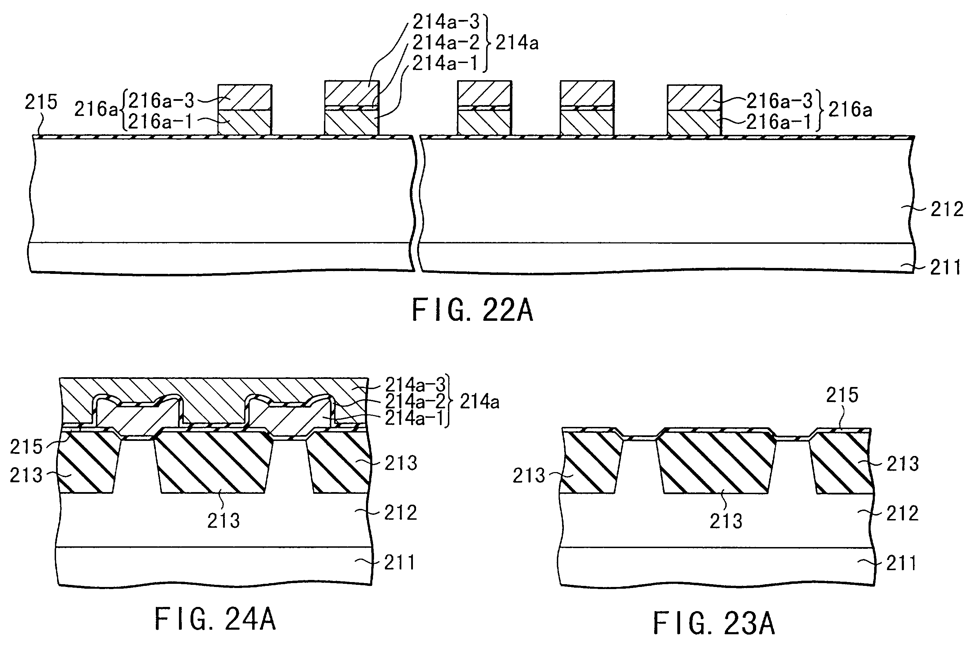

Next, referring to FIGS. 22A to 22G, FIGS. 23A to 23G, and FIGS. 24A to 24G, a method of manufacturing a memory cell array constructed as described above will be explained.

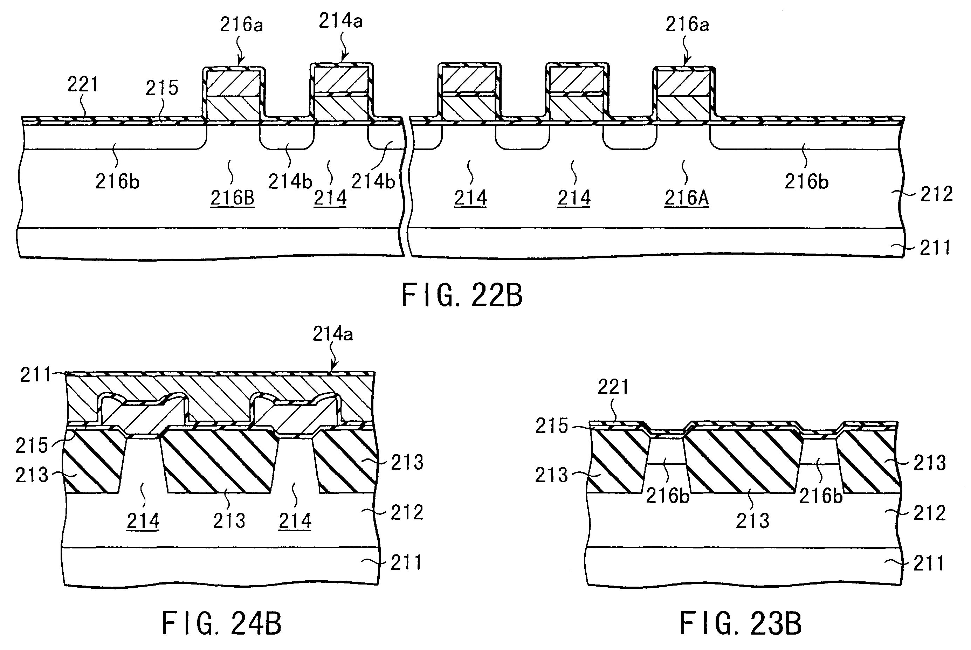

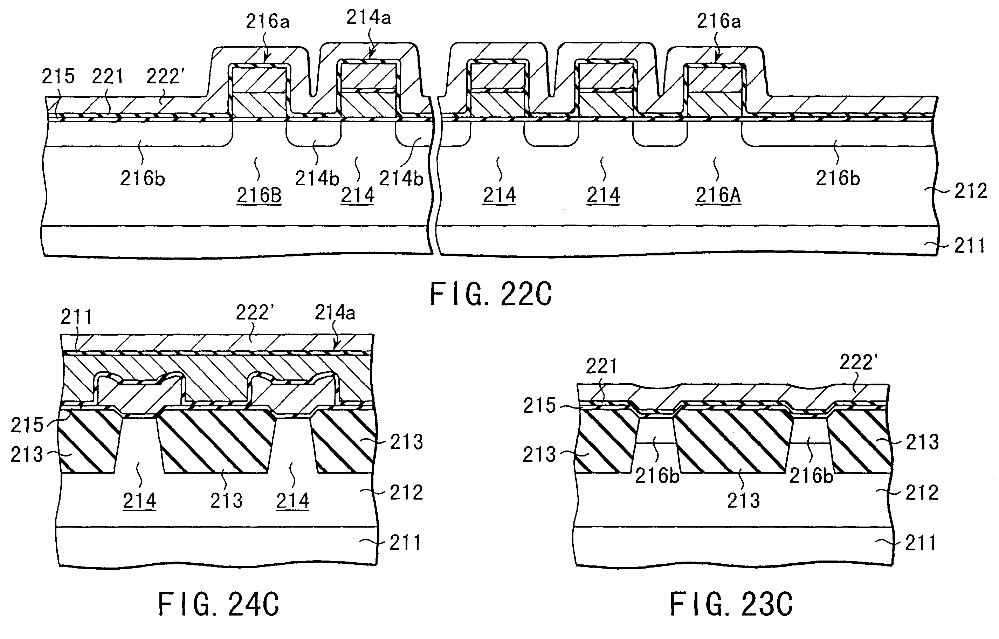

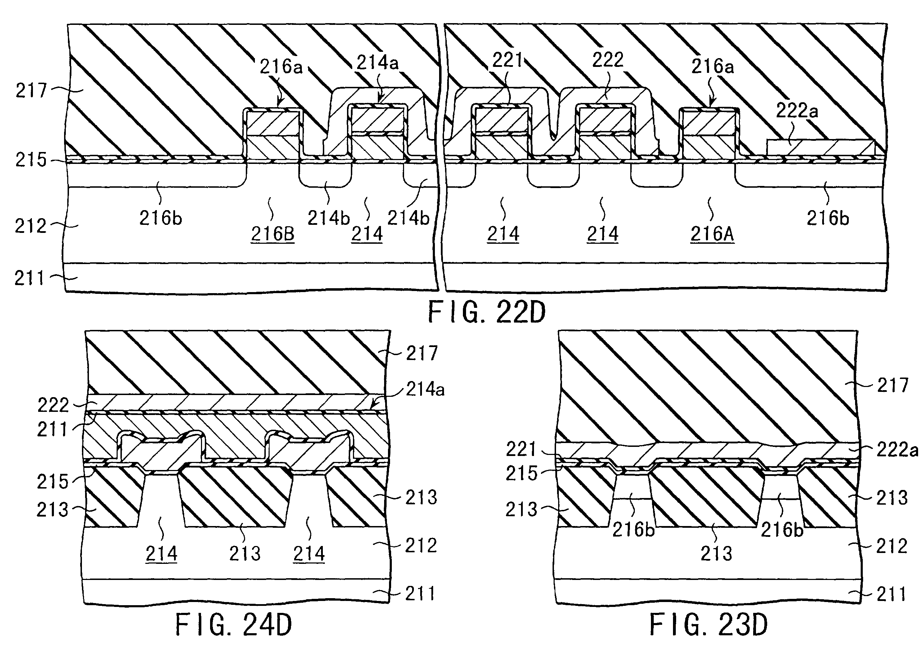

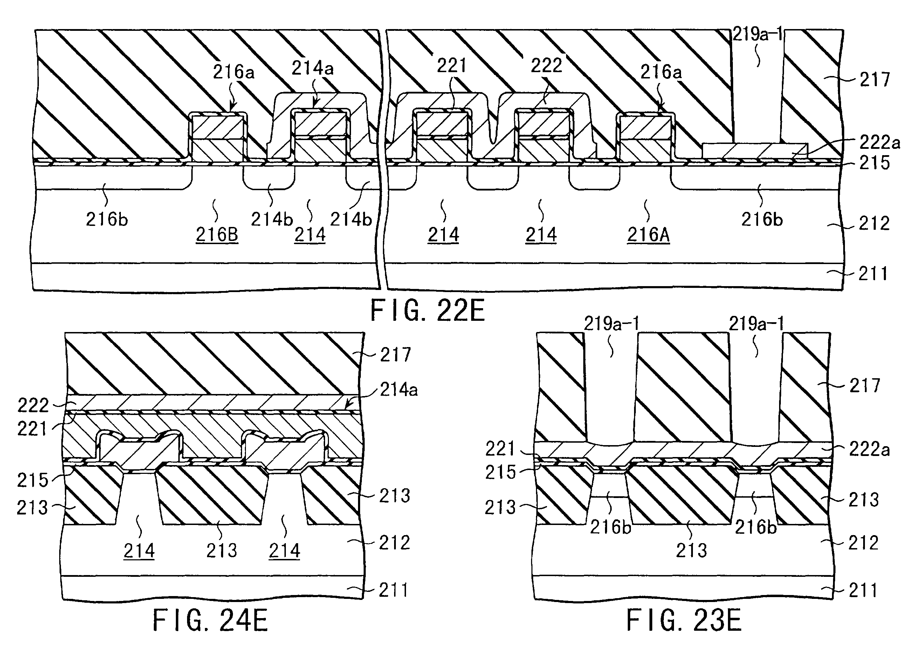

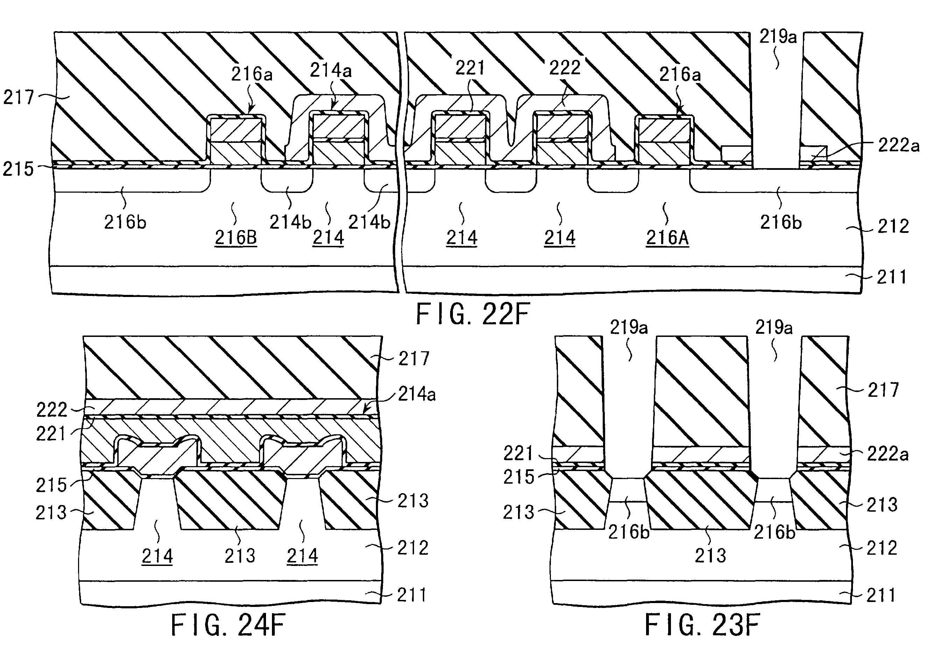

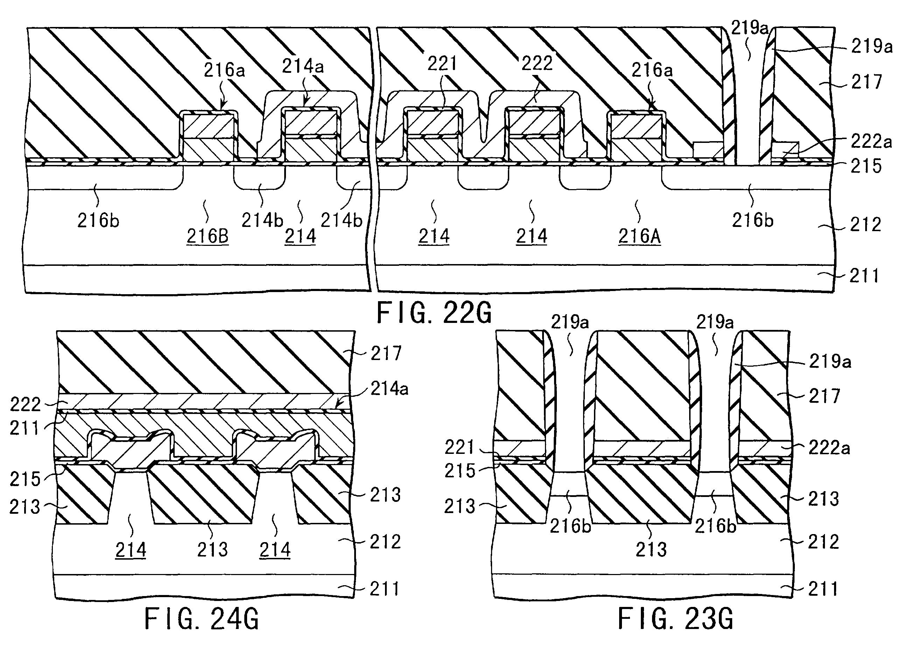

FIGS. 22A to 22G correspond to the cross section taken along line 20B-20B of FIG. 20A. FIGS. 23A to 23G correspond to the cross section taken along line 20C-20C of FIG. 20A. FIGS. 24A to 24G correspond to the cross section taken along line 20D-20D of FIG. 20A.

First, as shown in FIGS. 22A, 23A, and 24A, after the well region 212 and the STI structure element isolating region 213 have been formed at the main surface of the semiconductor substrate 211 using known techniques, the gate electrode section 214a of the memory cell 214 and the gate electrodes 216a of the drain-side select gate 216A and source-side select gate 216B are formed similarly to the existing NAND EEPROM.

At this time, an oxidation process may be carried out to form a gate sidewall oxide film of about 100 angstroms in thickness.

Then, as shown in FIGS. 22B, 23B, and 24B, impurities are introduced into the main surface of the semiconductor substrate 211 by ion implantation, thereby forming diffused layer regions 214b, 216b. Additionally, a silicon oxide film of about 500 angstroms in thickness is deposited all over the surface above the semiconductor substrate 311 by, for example, CVD (Chemical Vapor Deposition) techniques, thereby forming a plate insulating film 21.

Then, as shown in FIGS. 22C, 23C, and 24C, a polycrystalline silicon film 222' to form a booster plate 222 is deposited on the plate insulating film 221 by CVD techniques.

Next, as shown in FIGS. 22D, 23D, and 24D, the polycrystalline silicon film 222' is patterned by a photolithographic method, thereby etching away part of the silicon film 222'. As a result, the booster plate 222 is formed so as to cover the gate electrode sections 214a of at least part of the memory cells 214 and an etching stop layer 222a is formed on the top surface of each diffused layer region 216b of the drain-side select gate 216A.

Furthermore, an interlayer insulating film 217 of about 10000 angstroms in thickness is deposited all over the surface above the semiconductor substrate 211.

Then, as shown in FIGS. 22E, 23E, and 24E, a contact hole (first opening) 219a-1 reaching the etching stop layer 222a is made by a photolithographic method to form a bit line contact 219 in the interlayer insulating film 217. In this case, when the interlayer insulating film 217 is etched, it is relatively easy to give selectivity to the polycrystalline silicon film 222', which stops the etching surely at the time when the etching stop layer is exposed. As a result, it is possible to prevent the element isolating region 213 and the like from being etched more than is necessary.

Then, the etching stop layer 22a exposed at the bottom of the contact hole 219a-1 is etched away, thereby making a contact hole (second opening) reaching the underlying plate insulating film 221. In this case, too, when the etching stop layer 22a is etched, it is relatively easy to give selectivity to the plate insulating film 221, which stops the etching surely at the time when the etching stop layer is exposed, even if etching is done somewhat excessively.

Additionally, the plate insulating film 221 and tunnel oxide film 215 are etched away, thereby making a contact hole (third opening).

As a result of this, a contact hole 219a reaching the diffused layer region 216b is finally made. In this case, as a result of excess etching, the element isolating region 213, which should not have been etched, has been etched. The plate insulating film 221 and tunnel oxide film 215 are thin. Therefore, the absolute amount of excess etching is smaller than the amount of excess etching when the interlayer insulating film 217 is etched. As a result, the amount by which the element isolating region is etched can be reduced.

Then, as shown in FIGS. 22G, 23G, and 24G, a sidewall insulating film 219c is formed in the contact hole 219a. In this case, the sidewall insulating film 219c is formed in such a manner that a silicon oxide film is deposited all over the surface and then anisotropic etching is effected to leave the silicon oxide film only on the inner wall face of the contact hole 219a.

Thereafter, the filler 219b is embedded in the contact hole 219a and the bit line 218 is patterned, thereby completing a NAND EEPROM memory cell array of the structure shown in FIGS. 20A to 20D.

As described above, the etching of the interlayer insulating film in making the contact hole to form a bit line contact can be stopped temporarily at the time when the etching stop layer is exposed.

Specifically, a conductive layer, which is used as a booster plate, is formed so as to cover the gate electrode section of the memory cell. At the same time, the conductive layer is also formed on the bottom of the bit line contact. This enables the conductive layer to be used as an etching stopper in making a contact hole. As a result, not only are the characteristics of the device improved, but also the contact hole is prevented from being etched excessively. Because the element isolating region is prevented from being etched more than is necessary, not only are the characteristics of the device improved, but also faulty operations stemming from the processes in making a contact hole, such as the occurrence of punch-through between bit lines, can be eliminated.

Since the etching stop layer is formed simultaneously with the booster plate, there is no fear that the manufacturing processes become complex.

In the seventh embodiment, the etching stop layer 222a has been formed in a stripe in such a manner that it is provided integrally on the top surface of each diffused layer region 216b of the drain-side select gate 216A so as to be shared by the regions 216b. The present invention is not limited to this. For instance, the etching stop layer 222a may be provided independently on the top surface of each diffused layer region 216b of the drain-side select gate 216A.

As described above, with the nonvolatile semiconductor memory device and its manufacturing method according to the seventh embodiment, the etching of the interlayer insulating film in making a contact hole to form a contact section can be stopped temporarily at the time when the cover layer is exposed. This prevents the element isolation insulating film from being etched than is necessary.

### (Eighth Embodiment)

An eighth embodiment of the present invention relates to a NAND cell EEPROM with a booster plate.

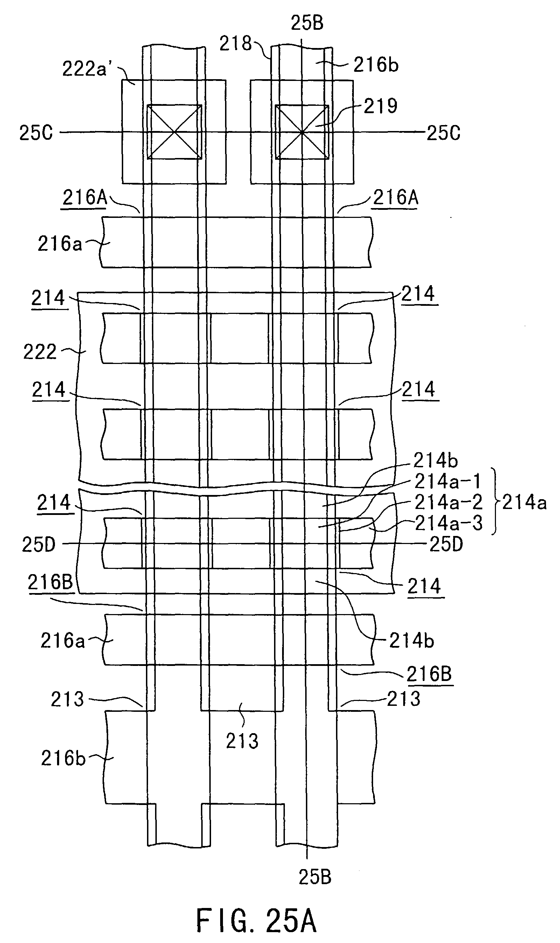

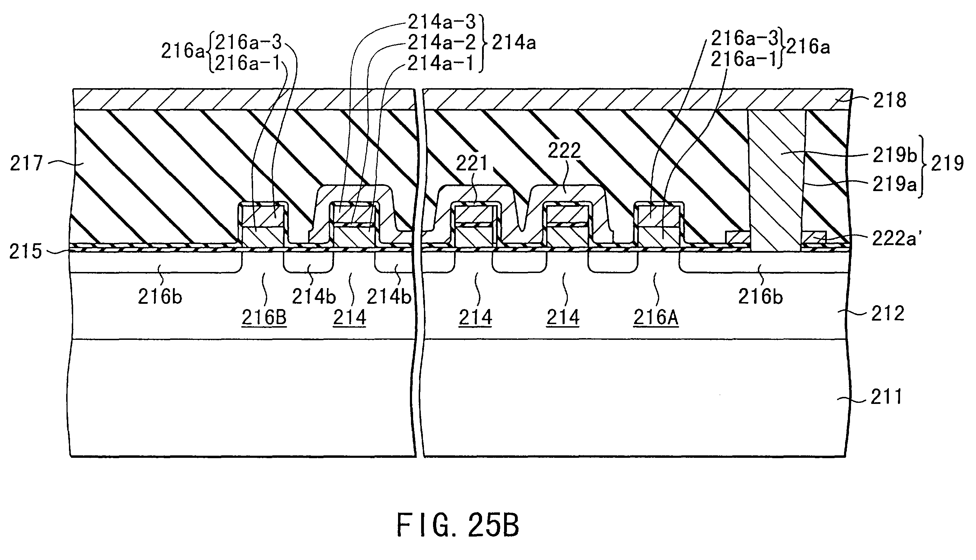

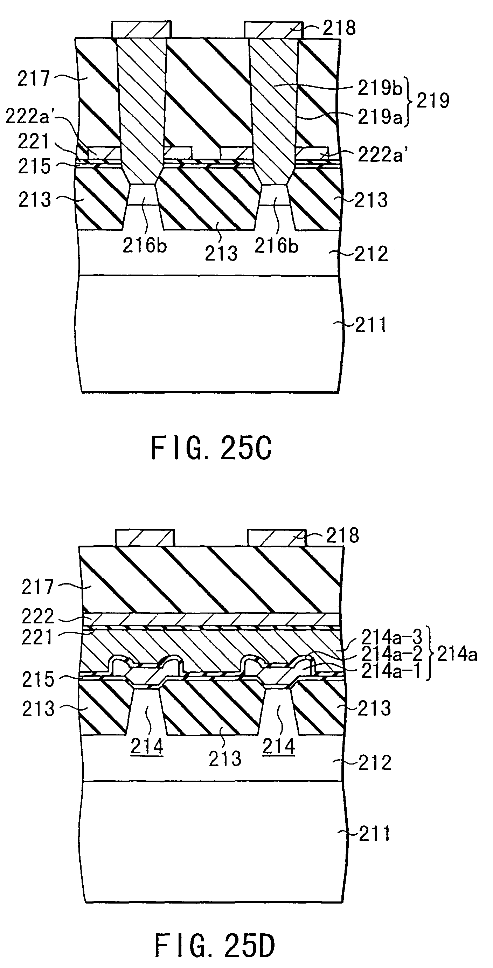

FIGS. 25A to 25D schematically show the configuration of a nonvolatile semiconductor memory according to the eighth embodiment in, for example, a memory cell array of a NAND EEPROM. FIG. 25A is a plan view showing the internal structure, FIG. 25B is a sectional view taken along line 25B-25B of FIG. 25A, FIG. 25C is a sectional view taken along line 25C-25C of FIG. 25A, and FIG. 25D is a sectional view taken along line 25D-25D of FIG. 25A.

In the memory cell array, etching stop layers 222a' are provided independently to adjacent bit line contacts 219 in such a manner that the layers 222a' are separated from each other. In this case, because there is no need to electrically insulate the bit line contacts 219 from each other to prevent them from short-circuiting with each other via the etching stop layers 222a', the formation of the sidewall insulating film 219c can be omitted.

With this configuration, the eighth embodiment not only produces almost the same effect as that of the seventh embodiment, but also enables remarkable simplification in terms of structure and manufacturing process.

The etching stop layer does not necessarily need to be formed at the same time when the booster plate 222 is formed. For instance, it may be formed at the same time when the source wires connected to the diffused layer regions (source lines) 216b of the source-side select gate 216B are formed.

### (Ninth Embodiment)

A ninth embodiment of the present invention relates to a NAND cell EEPROM with source wires connected to diffused layer regions 216b.

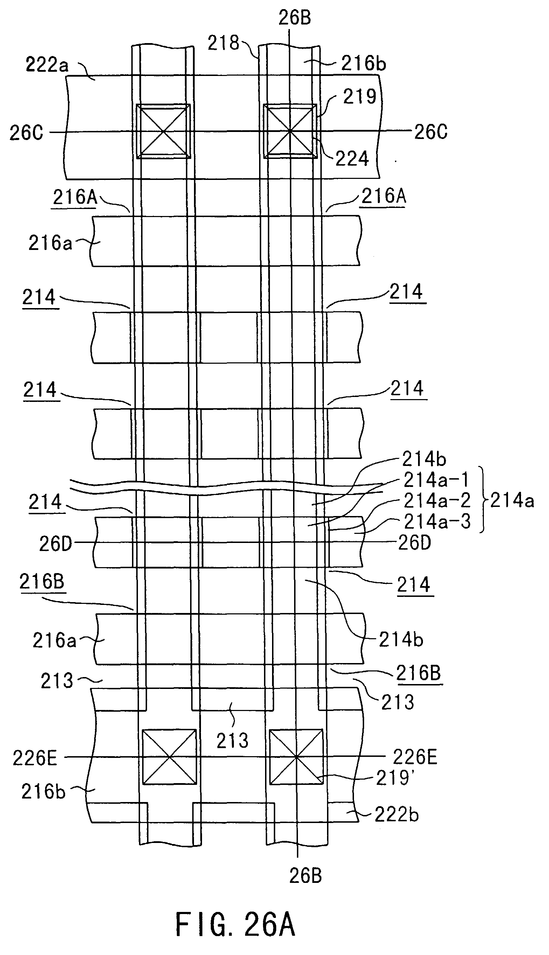

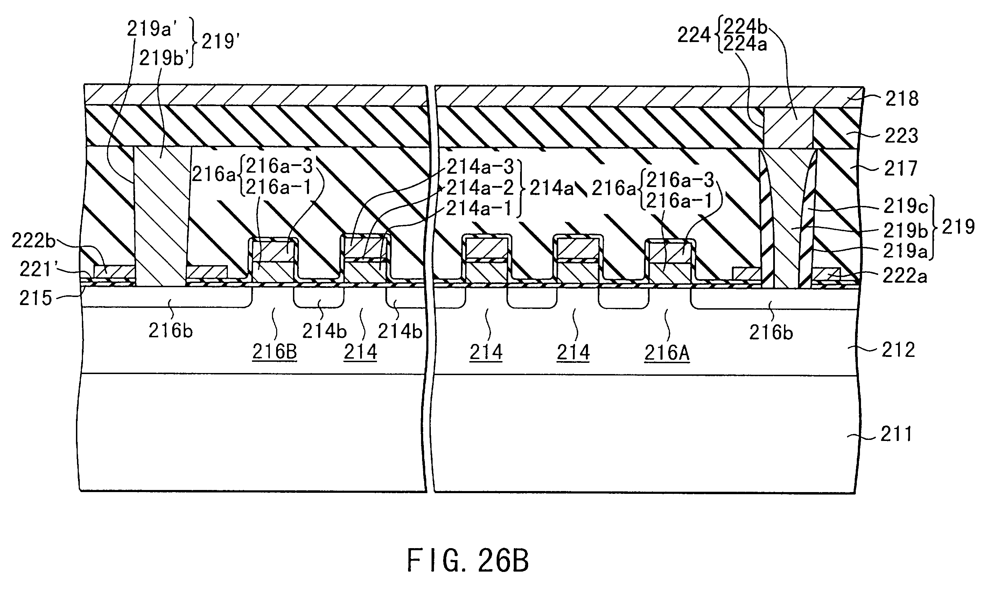

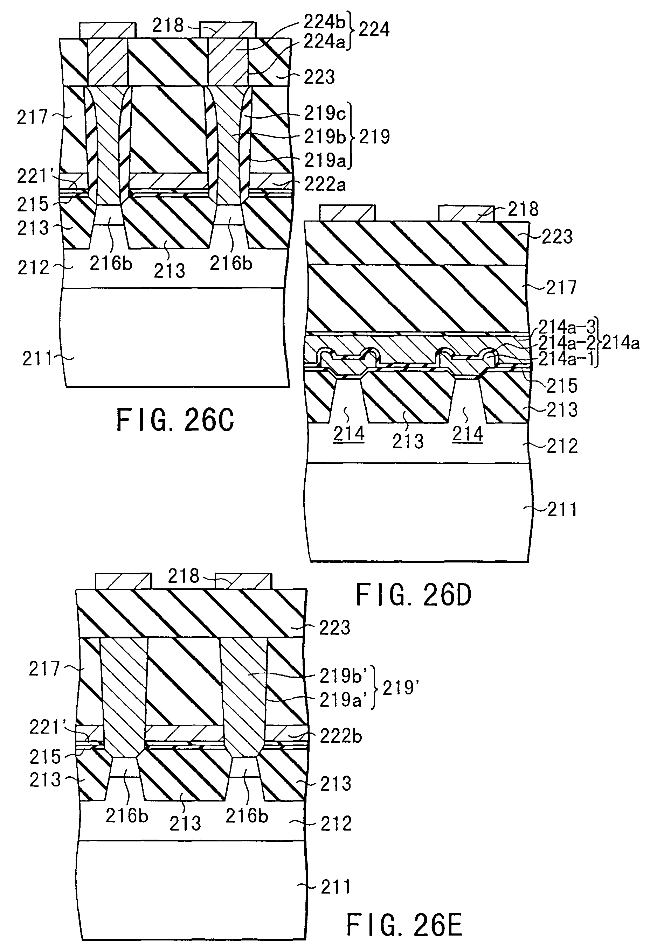

FIGS. 26A to 26E schematically show the configuration of a nonvolatile semiconductor memory according to the ninth embodiment in, for example, a memory cell array of a NAND EEPROM. FIG. 26A is a plan view showing the internal structure, FIG. 26B is a sectional view taken along line 26B-26B of FIG. 26A, FIG. 26C is a sectional view taken along line 26C-26C of FIG. 26A, FIG. 26D is a sectional view taken along line 26D-26D of FIG. 26A, and FIG. 26E is a sectional view taken along line 26E-26E of FIG. 26A.

In the memory cell array, for example, a conductive layer 222b to act as source wires is provided on the main surface of the semiconductor substrate 211 via the tunnel oxide film 215 and an insulating film 221' in such a manner that the conductive layer 222b covers common source regions (or each diffused layer region 216b of the source-side select gate 216B).

The conductive layer 222b is locally connected to the diffused layer region 216b via a source contact 219'. In this case, the conductive layer 222b is electrically short-circuited to the source contact 219', thereby functioning as a source wire.

The insulating film 221', which is provided so as to cover at least the main surface of the semiconductor substrate 211, is made of a silicon oxide film, a silicon nitride film, or a silicon oxynitride film, or a stacked film of those films.

The conductive layer 222b is composed of a polycrystalline silicon film (or tungsten polycide or the like) whose resistance has been made lower by doping a lot of impurities.

The source contact 219' is formed by filling a contact hole 219a' with conductive filler (or conductive material) 219b'. The contact hole 219a' is made so as to penetrate, for example, the interlayer insulating film 217, conductive layer 222b, insulating film 221', and tunnel oxide film 215.

On the other hand, an etching stop layer (cover layer) 222a is provided integrally on the top surface of each diffused layer region 216b of the drain-side select gate 216A via the tunnel oxide film 215 and insulating film 221'. The etching stop layer 222a is formed out of the polycrystalline silicon film whose resistance has been made lower by doping a lot of impurities and which constitutes the conductive layer 222b.

The bit line contact 219 penetrates through the interlayer insulating film 217, etching stop layer 222a, insulating film 221', and tunnel oxide film 215 and is connected to each diffused layer region 126b of the drain-side select gate 216A. Each bit line contact 219 is connected to the bit line 218 via a separate contact via 224 provided in the interlayer insulating film 223.

The interlayer insulating film 223 is formed to an almost uniform thickness on the entire surface of the interlayer insulating film 217, including, for example, the source contact 219' and the top surface of the bit line contact 219.

The contact via 224 is formed by filling a via hole 224a with conductive filler (or conductive material) 224b. The via hole 224a is made so as to penetrate through the interlayer insulating film 223.

In this case, too, the bit line contacts 219 are electrically insulated from each other in such a manner that a sidewall insulating film 219c is formed on the inner wall face of the contact hole 219a in contact with the etching stop layer 222a to prevent the bit line contacts 219 from being short-circuited to each other via the etching stop layer 222a.

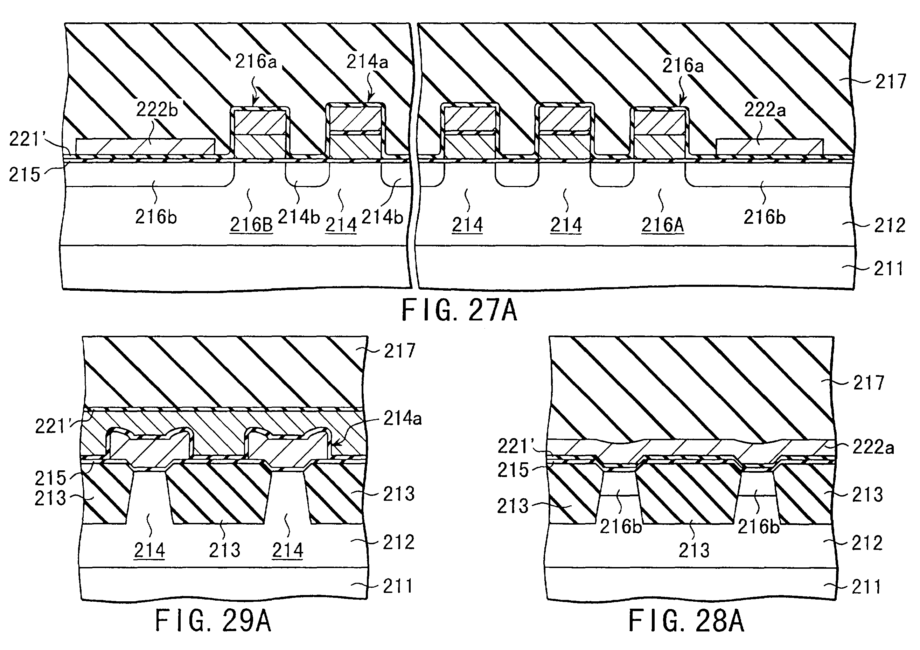

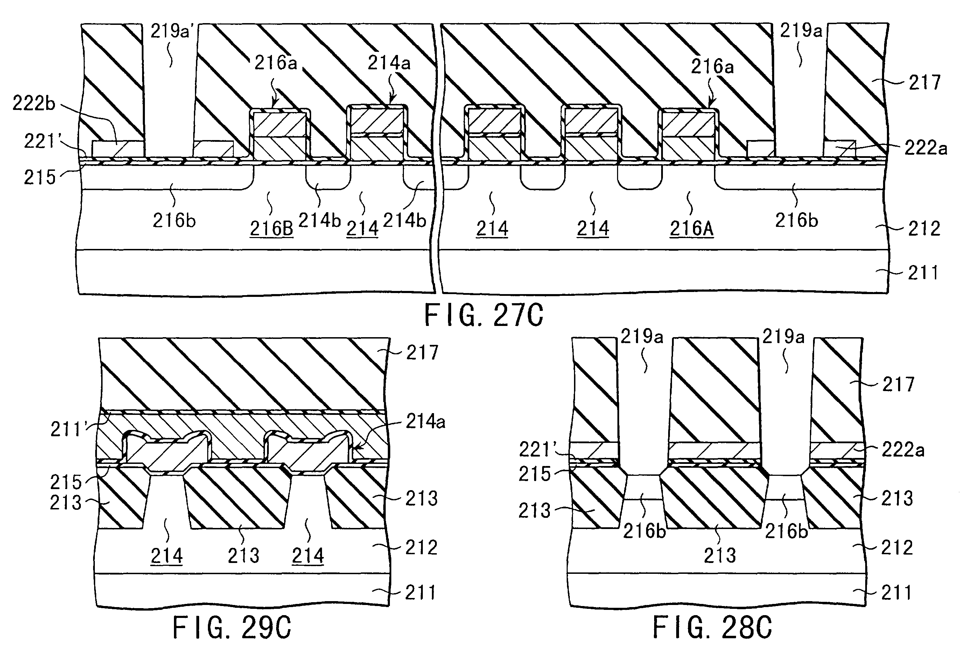

Next, referring to FIGS. 27A to 27D, FIGS. 28A to 28D, and FIGS. 29A to 29D, a method of manufacturing a memory cell array constructed as described above will be explained.

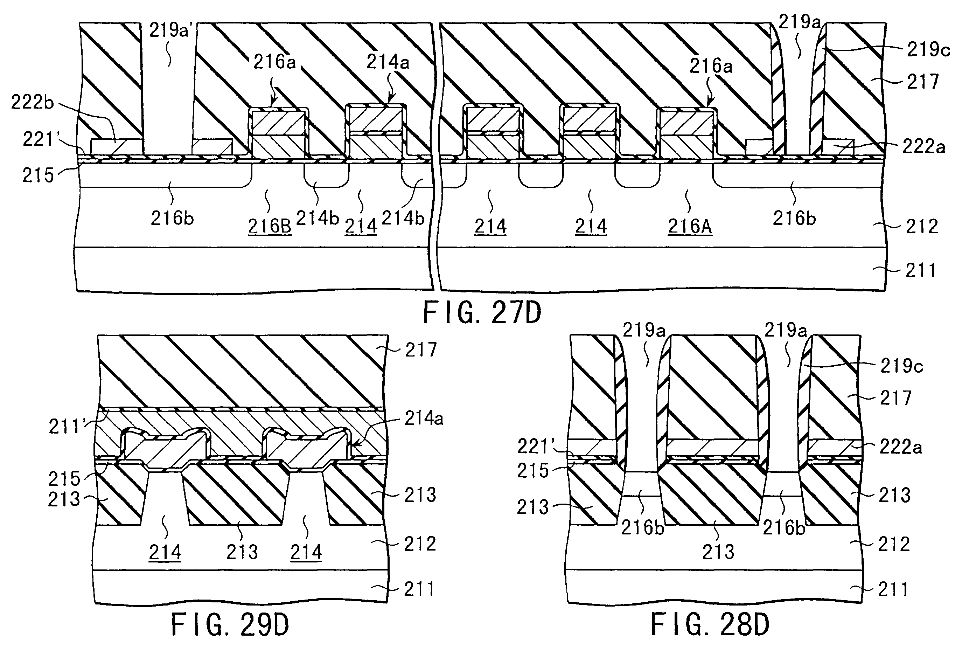

FIGS. 27A to 27D correspond to the cross section taken along line 26B-26B of FIG. 26A. FIGS. 28A to 28D correspond to the cross section taken along line 26C-26C of FIG. 26A. FIGS. 29A to 29D correspond to the cross section taken along line 26D-26D of FIG. 26A.

Since the processes up to depositing the polycrystalline silicon film 222' (the formation of the insulating film 221' is basically the same as that of the plate insulating film 221) are the same as those explained in seventh embodiment (see FIGS. 22A to 22C, FIGS. 23A to 23C, and FIGS. 24A to 24C), explanation of the processes will be omitted. Only the processes following those processes will be explained in detail.

For example, after a polycrystalline silicon film 222' has been deposited on the insulating film 221' by CVD techniques, the polycrystalline silicon film 222' is patterned by a photolithographic method, thereby etching away part of the silicon film 222'.

As a result, as shown in FIGS. 27A, 28A, and 29A, a conductive layer 222b to act as source wires is formed so as to cover each diffused layer region 216b of the source-side select gate 216B. At the same time, an etching stop layer 222a is formed on the top surface of each diffused layer region 216b of the drain-side select gate 216A.

Additionally, an interlayer insulating film 217 is deposited to a thickness of about 10000 angstroms all over the surface.

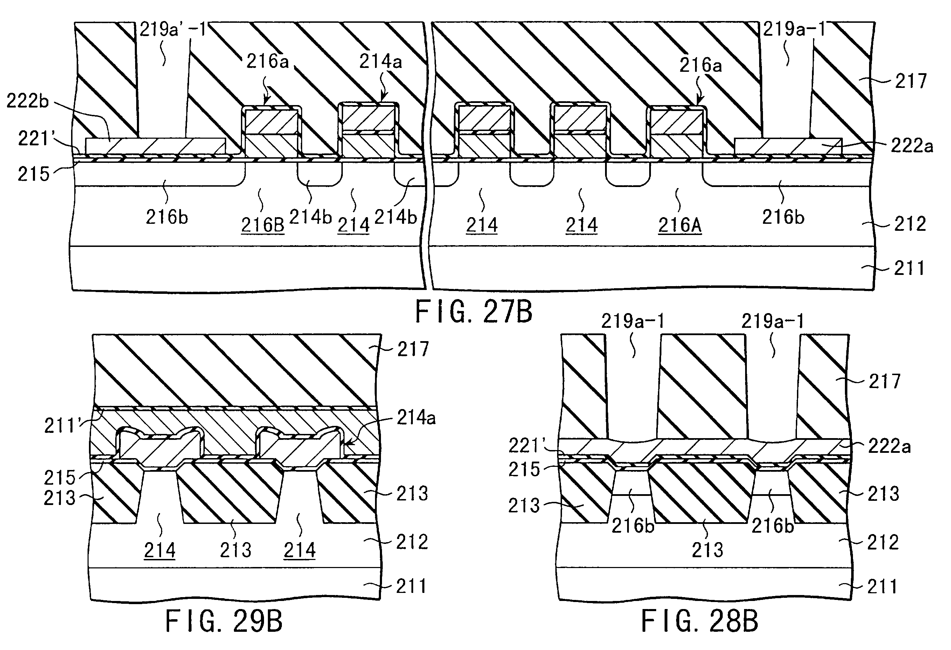

Then, as shown in FIGS. 27B, 28B, and 29B, a contact hole (first opening) 219a-1 reaching the etching stop layer 222a is made by a photolithographic method to form a bit line contact 219 in the interlayer insulating film 217. In addition, a contact hole (first opening) 219a-1' reaching the conductive layer 222b is made to form a bit line contact 219'.

In this case, too, since the etching is stopped surely at the time when the etching stop layer 222a and conductive layer 222b are exposed, it is possible to prevent the element isolating region from being etched more than is necessary.

Then, the etching stop layer 222a exposed at the bottom of the contact hole 219a-1 and the conductive layer 222b exposed at the bottom of the contact hole 219a-1' are etched away and a contact hole (second opening) reaching the underlying insulating film 221' is made.

In this case, too, when the etching stop layer 222a and conductive layer 222b are etched, it is relatively easy to give selectivity to the insulating film 221'. Thus, even if etching is done somewhat excessively, it is possible to stop the etching surely at the time when the insulating film 221' is exposed.

Furthermore, the insulating film 221' and tunnel oxide film 15 are etched away and a contact hole (third opening) is made.

As a result, contact holes 219a, 219a' reaching the diffused layer 216b are finally made as shown in FIGS. 27C, 28C, and 29C.

In this case, too, as a result of excess etching, the element isolating region 213, which should not have been etched, has been etched. The insulating film 221' and tunnel oxide film 215 are thin. Therefore, the absolute amount of excess etching is smaller than the amount of excess etching when the interlayer insulating film 217 is etched. As a result, the amount by which the element isolating region 213 is etched can be reduced.

Then, as shown in FIGS. 27D, 28D, and 29D, a sidewall insulating film 219c is formed only in the contact hole 219a. In this case, the sidewall insulating film 219c is formed in such a manner that a silicon oxide film is deposited all over the surface and then anisotropic etching is effected to leave the silicon oxide film only on the inner wall face of the contact holes 219a, 219a'. Then, only the silicon oxide film remaining on the inner wall face of the contact hole 219a' is selectively removed.

Then, after the contact hole 219a has been filled with filler 219b and contact hole 219a' has been filled with filler 219' (the fillers 219b, 219b' are basically the same material), an interlayer insulating film 223 is deposited all over the surface. Then, a via hole 224a reaching the bit line contact 219 is made in the interlayer insulating film 223.

Thereafter, the filler 219b is embedded in the via hole 224a and the bit line 218 is patterned, thereby completing a NAND EEPROM memory cell array of the structure shown in FIGS. 26A to 26E.

With this configuration, the conductive layer 222b has been provided on the diffused layer region 216b of the source-side select gate 216B and is used as a source wire. At the same time, another conductive layer (etching stop layer 222a) has been formed at the bottom of the bit line contact 219. This enables the conductive layers to act as etching stoppers in making the contact hole 219a.

As a result, when the bit line contact 219 is formed, the contact hole 219a is prevented from being etched excessively. This not only prevents the element isolating region 213 and others from being etched more than is necessary, but also decreases the resistance of the source line (source-side select gate 216B). Consequently, the reliability of the memory cell 214 is improved (because faulty operations are prevented) and the area of the memory cell array is decreased as a result of a reduction in the number of common source lines connected to the individual source lines. Therefore, an improvement in the characteristics of the device and an improvement in the controllability in manufacturing processes can be realized at the same time.

As in the eighth embodiment, in the ninth embodiment, the etching stop layer 222a may be provided independently on the top surface of each diffused layer region 216b of the drain-side select gate 216A.

### (Tenth Embodiment)

A tenth embodiment of the present invention relates to a NAND cell EEPROM with source wires connected to diffused layer regions 216b.

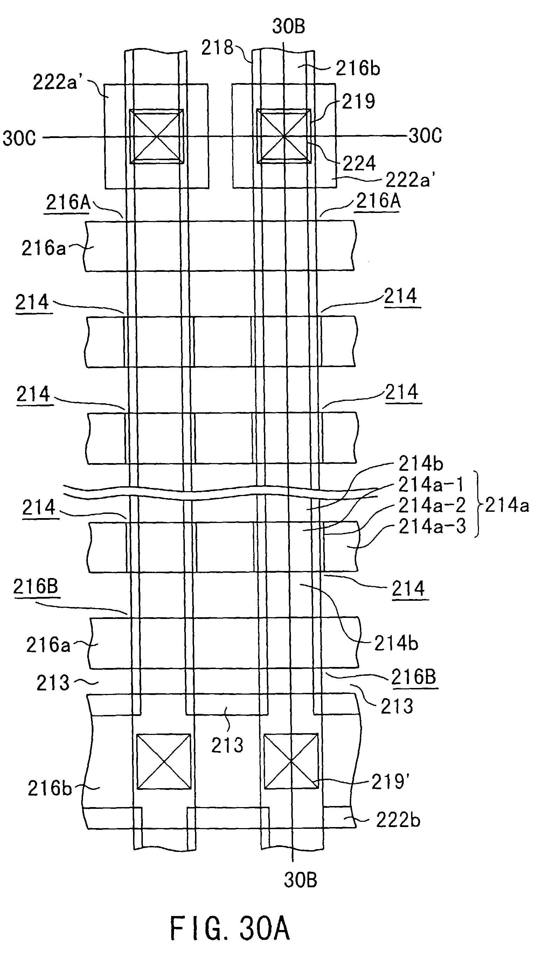

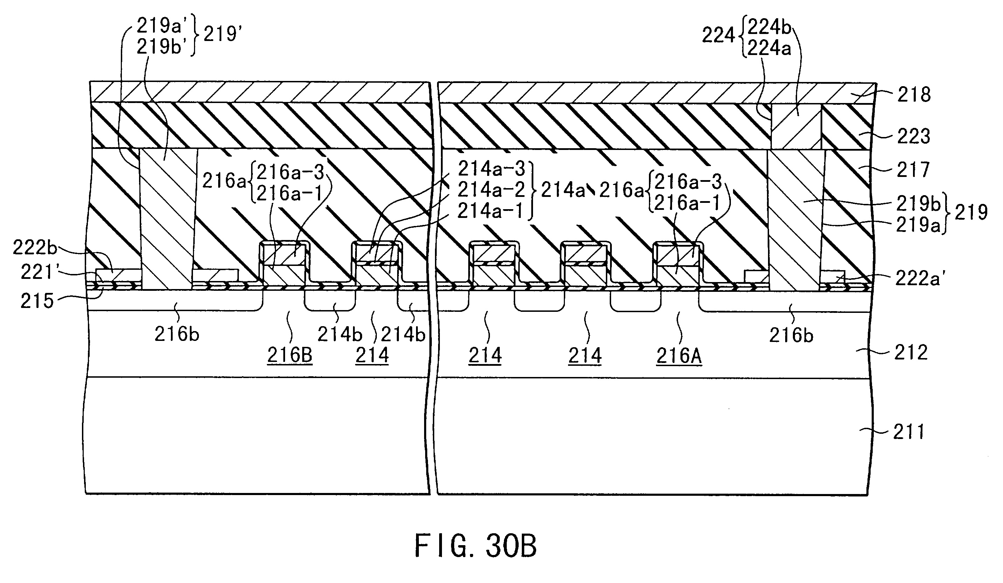

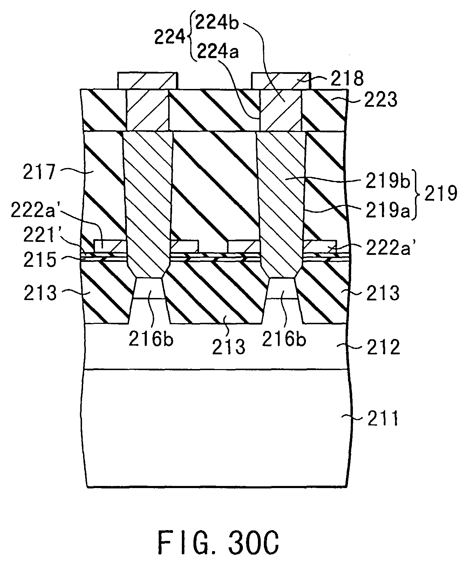

FIGS. 30A to 30C schematically show the configuration of a nonvolatile semiconductor memory according to the tenth embodiment in, for example, a memory cell array of a NAND EEPROM. FIG. 30A is a plan view showing the internal structure, FIG. 30B is a sectional view taken along line 30B-30B of FIG. 30A, and FIG. 30C is a sectional view taken along line 30C-30C of FIG. 30A.

In the memory cell array, etching stop layers 222a' are provided independently to adjacent bit line contacts 219 in such a manner that they are separated from each other. In this case, because there is no need to electrically insulate the bit line contacts 219 from each other to prevent them from short-circuiting with each other via the etching stop layers 222a', the formation of the sidewall insulating film 219c can be omitted.

With this configuration, like the eighth embodiment, the tenth embodiment enables remarkable simplification in terms of structure and manufacturing process.

In the ninth and tenth embodiments, the diffused layer region 216b of the source-side select gate 216b does not necessarily need to be formed as a common source region shared by the adjacent source-side select gates 216B in the direction of row line. The diffused layer regions 216b may be provided separately by causing the element isolating region 213 to extend between the diffused layer regions 216b of the adjacent source-side select gates 216B.

In addition to forming either the booster plate or the source wires, for example, an etching stop layer may be formed on the diffused layer region of the drain-side select gate at the same time when a booster plate and source wires are formed.

The present invention may be practiced or embodied in still other ways without departing from the spirit or essential character thereof.

As described above, with the seventh to tenth embodiments, it is possible to provide a nonvolatile semiconductor memory device capable of preventing faulty operations owing to the accuracy of work in making a contact hole and improving the characteristics and the reliability of the device.

## Claims

1. A semiconductor device characterized by comprising:
a semiconductor substrate (2) having an element isolating region (4) and an element formation region;
a transistor having a first and a second diffused layer (9) formed in the element formation region and a gate electrode structure (5, 6, 7, 8) formed on the element formation region between the first and second diffused layers; and
a barrier insulating film (12) formed on the element isolating region and the element formation region except for a portion near the gate electrode structure.

2. The semiconductor device according to claim 1, characterized in that the semiconductor substrate (2) is made of silicon, the element isolating region (4) is trench isolation of silicon oxide, and the barrier insulating film (9) is made of silicon nitride.

3. The semiconductor device according to claim 1 or 2, characterized in that the transistor is a memory cell transistor (MC) in a nonvolatile semiconductor memory,
the gate electrode structure of the memory cell transistor includes a gate insulating film (5) formed on the element formation region, a floating gate (6) formed on the gate insulating film, a gate-to-gate insulating film (7) formed on the floating gate, and a control gate (8) formed on the gate-to-gate insulating film,
the nonvolatile semiconductor memory includes a memory cell unit (40) including at least one unit of the memory cell transistor, and a select transistor (SST, SDT) having a first and a second diffused layer formed in the element formation region and a gate electrode structure formed on the element formation region between the first and second diffused layers, the select transistor serving to select the memory cell unit, and
the barrier insulating film (12) is formed on either the first or second diffused layer of the select transistor and the element isolating region adjacent to the either the first or second diffused layer of the select transistor.

4. The semiconductor device according to claim 3, characterized in that the memory cell units (40) are composed of either NAND cells or AND cells.

5. A method of manufacturing a semiconductor device characterized by comprising:
forming an element isolating region (4) in a semiconductor substrate (2) to separate element formation regions from each other in the semiconductor substrate;
forming a gate electrode structure (5, 6, 7, 8) on the element formation region;
doping dopant into the element formation regions using at least the gate electrode structure as a mask;
forming a barrier insulating film (12) above the element formation regions, above the element isolating region, and above the gate electrode structure; and
removing the barrier insulating film (12) from above the vicinity of the gate electrode structure.

6. The method of manufacturing a semiconductor device according to claim 5, characterized by further comprising the step of:
forming a sidewall insulating film (11) on the sidewall of the gate electrode structure before doping the dopant.

7. The method of manufacturing a semiconductor device according to claim 6, characterized by further comprising:
forming a mask insulating film (13) with an etching rate differing from the etching rate of the barrier insulating film, on the barrier insulating film before removing the barrier insulating film; and
removing the mask insulating film (13) from above the vicinity of the gate electrode structure.

8. The method of manufacturing a semiconductor device according to one of claim 5 to claim 7, characterized by further comprising:
annealing at least the sidewall insulating film (11) to improve the quality of the sidewall insulating film; and
annealing the dopant at least in the element formation region to activate the dopant.

9. A semiconductor device characterized by comprising:
a semiconductor substrate (211) having an element isolating region (213) and an element formation region;
a memory cell unit including at least one memory cell transistor (214) formed in the element formation region;
a drain-side select transistor (216A) formed in the element formation region, the source of the drain-side select transistor being connected to one end of the current path of the memory cell unit;
a source-side select transistor (216B) formed in the element formation region, the drain of the source-side select transistor being connected to the other end of the current path of the memory cell unit;
a booster plate (222) formed via an insulating film (221) above the memory cell transistor; and
a cover layer (222a) which is formed via the insulating film above the drain of the drain-side select transistor and is composed of the same layer as that of the booster plate.

10. A semiconductor device characterized by comprising:
a semiconductor substrate (211) having an element isolating region and an element formation region;
a memory cell unit including at least one memory cell transistor (214) formed in the element formation region;
a drain-side select transistor (216A) formed in the element formation region, the source of the drain-side select transistor being connected to one end of the current path of the memory cell unit;
a source-side select transistor (216B) formed in the element formation region, the drain of the source-side select transistor being connected to the other end of the current path of the memory cell unit;
a source line (222b) formed via an insulating film above the source of the source-side select transistor; and
a cover layer (222a) which is formed via the insulating film above the drain of the drain-side select transistor and is composed of the same layer as that of the source line.

11. The semiconductor device according to claim 9 or 10, characterized in that the memory cell transistor has a gate electrode structure including a gate insulating film (215) formed on the element formation region, a floating gate (214a-1) formed on the gate insulating film, a gate-to-gate insulating film (214a-2) formed on the floating gate, and a control gate (214a-3) formed on the gate-to-gate insulating film.

12. The semiconductor device according to claim 10, characterized by further comprising:
a source line contact (219') which penetrates through the source line and the insulating film and reaches the source of the source-side select transistor, wherein
the source line is electrically connected to the source of the source-side select transistor via the source line contact.

13. The semiconductor device according to claim 9 or 10, characterized by further comprising:
an interlayer insulating film (217) formed above the semiconductor substrate;
a bit line contact (219) which penetrates through the interlayer insulating film, the cover layer, and the insulating film and reaches the drain of the drain-side select transistor; and
a bit line (218) which is formed on the interlayer insulating film and electrically connected to the drain of the drain-side select transistor via the bit line contact.

14. The semiconductor device according to claim 9 or 10, characterized in that
the memory cell units, the drain-side select transistors, and the source-side select transistors are arranged in a matrix in the direction of bit line and the direction almost perpendicular to the direction of bit line, and
the cover layer is shared by the drain-side select transistors arranged in the direction almost perpendicular to the direction of bit line.

15. The semiconductor device according to claim 14, characterized in that the cover layer is conductive and is electrically insulated from the bit line contact.

16. The semiconductor device according to claim 9 or 10, characterized in that
the memory cell units, the drain-side select transistors, and the source-side select transistors are arranged in a matrix in the direction of bit line and the direction almost perpendicular to the direction of bit line, and
the cover layer is formed for each of the drain-side select transistors arranged in the direction almost perpendicular to the direction of bit line.

17. A method of manufacturing a semiconductor device characterized by comprising:
forming an element isolating region (213) in a semiconductor substrate to separate element formation regions in the semiconductor substrate;
forming a memory cell unit including at least one memory cell transistor (214), a drain-side select transistor (216A) whose source is connected to one end of the current path of the memory cell unit, and a source-side select transistor (216B) whose drain is connected to the other end of the current path of the memory cell unit are formed in a matrix in the direction of bit line and the direction almost perpendicular to the direction of bit line;
forming a conductive layer (222') via an insulating film (221) above the semiconductor substrate;
patterning the conductive layer to form a booster plate (222) above the memory cell transistor and a cover layer (222a) above the drain of the drain-side select transistor;
forming an interlayer insulating film (217) above the semiconductor substrate;
making a first opening (219a-1) reaching the cover layer in the interlayer insulating film;
removing the cover layer exposed at the bottom of the first opening to make a second opening reaching the insulating film;
removing the insulating film exposed at the bottom of the second opening to make a third opening reaching the drain of the drain-side select transistor;
forming bit line contacts (219) in the first, second, and third openings; and
forming a bit line (218) connected to the bit line contacts on the interlayer insulating film.

18. A method of manufacturing a semiconductor device characterized by comprising:
forming an element isolating region (213) in a semiconductor substrate to separate element formation regions in the semiconductor substrate;
forming a memory cell unit including at least one memory cell transistor (214), a drain-side select transistor (216A) whose source is connected to one end of the current path of the memory cell unit, and a source-side select transistor (216B) whose drain is connected to the other end of the current path of the memory cell unit are formed in a matrix in the direction of bit line and the direction almost perpendicular to the direction of bit line;
forming a conductive layer (222') via an insulating film (221) above the semiconductor substrate;
patterning the conductive layer to form a source line (222b) above the source of the source-side select transistor and a cover layer (222a) above the drain of the drain-side select transistor;
forming an interlayer insulating film (217) above the semiconductor substrate;
making a first opening (219a-1) reaching the cover layer in the interlayer insulating film;
removing the cover layer exposed at the bottom of the first opening to make a second opening reaching the insulating film;
removing the insulating film exposed at the bottom of the second opening to make a third opening reaching the drain of the drain-side select transistor;
forming bit line contacts (219) in the first, second, and third openings; and
forming a bit line (218) connected to the bit line contacts on the interlayer insulating film.

19. The method of manufacturing a semiconductor device according to claim 17 or 18, characterized in that the cover layer is formed continuously in the direction almost perpendicular to the direction of bit line.

20. The method of manufacturing a semiconductor device according to claim 19, characterized in that a sidewall insulating film is formed on the sidewalls of the first, second, and third openings, after the third opening has been made.

21. The method of manufacturing a semiconductor device according to claim 17 or 18, characterized in that the cover layer is formed for each drain-side select transistor arranged in the direction almost perpendicular to the direction of bit line.

22. The method of manufacturing a semiconductor device according to claim 17, characterized in that the booster plate is formed so as to cover the top and side faces of the gate electrode structure of the memory cell transistor.
